(19) Europäisches Patentamt
European Patent Office
Office européen des brevets

(11) EP 3 316 326 A1

(12) # EUROPEAN PATENT APPLICATION
published in accordance with Art. 153(4) EPC

(43) Date of publication:
**02.05.2018 Bulletin 2018/18**

(21) Application number: **16814348.5**

(22) Date of filing: **21.06.2016**

(51) Int Cl.:
***H01L 51/44*** *(2006.01)*

(86) International application number:
**PCT/JP2016/068385**

(87) International publication number:
**WO 2016/208578 (29.12.2016 Gazette 2016/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **26.06.2015 JP 2015128512**

(71) Applicant: **FUJIFILM Corporation**
**Tokyo 106-8620 (JP)**

(72) Inventors:
- **SATOU, Hirotaka**
**Ashigarakami-gun**
**Kanagawa 258-8577 (JP)**
- **HANAKI, Naoyuki**
**Ashigarakami-gun**
**Kanagawa 258-8577 (JP)**
- **ISE, Toshihiro**
**Ashigarakami-gun**
**Kanagawa 258-8577 (JP)**

(74) Representative: **Hoffmann Eitle**
**Patent- und Rechtsanwälte PartmbB**
**Arabellastraße 30**
**81925 München (DE)**

(54) **PHOTOELECTRIC CONVERSION ELEMENT AND SOLAR BATTERY**

(57) Provided are a photoelectric conversion element and a solar cell using the photoelectric conversion element. The photoelectric conversion element includes: a first electrode that includes a photosensitive layer, which includes a perovskite-type light absorbing agent, on a conductive support; a particle-containing layer that contains conductive fine particles and a polymer and is provided on the first electrode; and a charge transport layer that does not contain the conductive fine particles and is provided between the photosensitive layer and the particle-containing layer.

FIG. 1

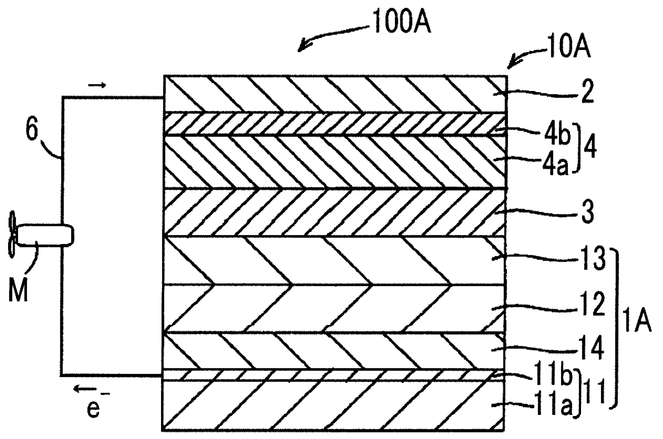


EP 3 316 326 A1

## Description

## BACKGROUND OF THE INVENTION

1. Field of the Invention

The present invention relates to a photoelectric conversion element and a solar cell.

2. Description of the Related Art

Photoelectric conversion elements are used in a variety of optical sensors, copiers, solar cells, and the like. It is expected that solar cells will be actively put into practical use as cells using non-exhaustible solar energy. Among these, research and development of dye sensitized solar cells, in which an organic dye, a Ru bipyridyl complex, or the like is used as a sensitizer, are actively in progress, and the photoelectric conversion efficiency thereof reaches approximately 11%.

Meanwhile, in recent years, there have been reported research results indicating that solar cells using a metal halide having a perovskite-type crystal structure as a light absorbing agent are capable of achieving relatively high photoelectric conversion efficiency, and the solar cells attract attention.

For example, Science, 2012, vol. 338, p. 643 to 647 discloses a solar cell that uses a metal halide represented by $CH_3NH_3PbI_2Cl$ as the light absorbing agent. Nano lett, 2014, 14, p. 5561 to 5568 discloses a solar cell including a layer, in which a single-layer carbon nanotube coated with poly(3-hexylthiophene) is embedded in an insulating polymer, on a layer of $CH_3NH_3PbI_{(3-x)}Cl_x$.

## SUMMARY OF THE INVENTION

In photoelectric conversion elements using a compound (hereinafter, referred to as "perovskite compound) having the perovskite-type crystal structure as the light absorbing agent, a constant improvement in photoelectric conversion efficiency is attained. However, in the photoelectric conversion element that uses the perovskite compound as the light absorbing agent, initial photoelectric conversion efficiency (at the time of manufacturing) is likely to vary, and thus it is required to reduce a variation in initial performance between elements in practical use as a solar cell. In addition, in the photoelectric conversion element using the perovskite compound, typically, the photoelectric conversion efficiency (battery performance) is likely to deteriorate with the passage of time. In addition, a deterioration amount of the photoelectric conversion efficiency after passage of a predetermined period greatly fluctuates between elements, and thus it can be seen that stability of the photoelectric conversion efficiency is not sufficient in addition to the variation in the initial photoelectric conversion efficiency.

An object of the invention is to provide a photoelectric conversion element and a solar cell in which a variation in initial photoelectric conversion efficiency between elements is small and stability of photoelectric conversion efficiency is also excellent even in photoelectric conversion elements using a perovskite compound as a light absorbing agent.

The present inventors have obtained the following finding. In a photoelectric conversion element or a solar cell which uses a perovskite compound as a light absorbing agent, in a case where a particle-containing layer, which contains conductive fine particles and a polymer, is provided on an upper side of a photosensitive layer including a perovskite-type light absorbing agent, and a charge transport layer, which does not include the conductive fine particles, is additionally provided between the particle-containing layer and the photosensitive layer, it is possible to obtain a photoelectric conversion element or a solar cell in which a variation (durability variation) in a deterioration amount of photoelectric conversion efficiency after passage of a predetermined period is also suppressed in addition to a variation in initial photoelectric conversion efficiency. The invention is accomplished by additionally repeating examinations on the basis of the finding.

That is, the above-described objects are accomplished by the following means.

<1> According to an aspect of the invention, there is provided a photoelectric conversion element comprising: a first electrode that includes a photosensitive layer, which includes a perovskite-type light absorbing agent, on a conductive support; a particle-containing layer that contains conductive fine particles and a polymer and is provided on the first electrode; and a charge transport layer that does not contain the conductive fine particles and is provided between the photosensitive layer and the particle-containing layer.

<2> In the photoelectric conversion element according to <1>, the charge transport layer may be a hole transport layer.

<3> In the photoelectric conversion element according to <1> or <2>, the polymer may be an insulating material.

<4> In the photoelectric conversion element according to any one of <1> to <3>, the conductive fine particles may be fine particles of a carbon material.

<5> The photoelectric conversion element according to any one of <1> to <4> may further comprise a second electrode that is opposite to the first electrode and is provided on the particle-containing layer.
<6> In the photoelectric conversion element according to any one of <1> to <4>, the particle-containing layer may also function as a second electrode that is opposite to the first electrode.
<7> In the photoelectric conversion element according to any one of <1> to <6>, the perovskite-type light absorbing agent may include a compound having a perovskite-type crystal structure that includes a cation of elements of Group 1 in the periodic table or a cationic organic group A, a cation of a metal atom other than elements of Group 1 in the periodic table, and an anion of an anionic atom or atomic group X.
<8> The photoelectric conversion element according to any one of <1> to <7> may further comprise a porous layer that is provided between the conductive support and the photosensitive layer.
<9> According to another aspect of the invention, there is provided a solar cell that uses the photoelectric conversion element according to any one of <1> to <8>.

In this specification, parts of respective formulae may be expressed as a rational formula for understanding of chemical structures of compounds. According to this, in the respective formulae, partial structures are called (substituent) groups, ions, atoms, and the like, but in this specification, the partial structures may represent element groups or elements which constitute (substituent) groups or ions represented by the formulae in addition to the (substituent) groups, the ions, the atoms, and the like.
In this specification, with regard to expression of compounds (including a complex and a dye), the expression is also used to indicate salts of the compounds and ions of the compounds in addition to the compounds. In addition, with regard to compounds for which substitution or non-substitution is not specified, the compounds also include compounds which have an arbitrary substituent group in a range not deteriorating a target effect. This is also true of substituent groups, linking groups, and the like (hereinafter, referred to as "substituent groups and the like").
In this specification, in a case where a plurality of substituent groups and the like expressed using specific symbols or a plurality of substituent groups and the like are simultaneously defined, the respective substituent groups and the like may be identical to or different from each other unless otherwise stated. This is also true of definition of the number of substituent groups and the like. In addition, in a case of approaching to each other (particularly, in a case of being close to each other), the plurality of substituent groups and the like may be bonded to each other to form a ring unless otherwise stated. In addition, rings, for example, alicycles, aromatic rings, and hetero rings may be additionally fused together to form a fused ring.
In this specification, numerical ranges represented by using "to" include ranges including numerical values before and after "to" as the lower limit and the upper limit.
In the photoelectric conversion element and the solar cell of the invention, even though using the perovskite compound as the light absorbing agent, both a variation in initial photoelectric conversion efficiency between elements and a variation in a deterioration amount of the photoelectric conversion efficiency after passage of a predetermined period are reduced.
The above-described and other characteristics and advantages of the invention will be further clarified from the following description with appropriate reference to the accompanying drawings.

## BRIEF DESCRIPTION OF THE DRAWINGS

Fig. 1 is a cross-sectional view schematically illustrating a preferred aspect of a photoelectric conversion element of the invention.
Fig. 2 is a cross-sectional view schematically illustrating another preferred aspect of the photoelectric conversion element of the invention.
Fig. 3 is a cross-sectional view schematically illustrating still another preferred aspect of the photoelectric conversion element of the invention.
Fig. 4 is a cross-sectional view schematically illustrating still another preferred aspect of the photoelectric conversion element of the invention.
Fig. 5 is a cross-sectional view schematically illustrating still another preferred aspect of the photoelectric conversion element of the invention.
Fig. 6 is a cross-sectional view schematically illustrating still another preferred aspect of the photoelectric conversion element of the invention.

## DESCRIPTION OF THE PREFERRED EMBODIMENTS

<<Photoelectric Conversion Element>>

A photoelectric conversion element of the invention includes a first electrode provided with a photosensitive layer, which contains a perovskite compound (also referred to as "perovskite-type light absorbing agent) used as a light absorbing agent, on a conductive support, and a charge transport layer and a particle-containing layer which are provided on the first electrode in this order.

In the invention, the aspect in which the photosensitive layer is provided on the conductive support includes an aspect in which the photosensitive layer is (directly) provided to be in contact with a surface of the conductive support, and an aspect in which the photosensitive layer is provided on an upper side of the surface of the conductive support through another layer.

In the aspect in which the photosensitive layer is provided on the upper side of the surface of the conductive support through another layer, as the other layer that is provided between the conductive support and the photosensitive layer, there is no particular limitation as long as the other layer does not deteriorate a battery performance of a solar cell. Examples of the other layer include a porous layer, a blocking layer, an electron transport layer and the like.

In the invention, examples of the aspect in which the photosensitive layer is provided on an upper side of the surface of the conductive support through another layer include an aspect in which the photosensitive layer is provided on a surface of the porous layer in a thin film shape or a thick film shape (Fig. 1 to Fig. 3), an aspect in which the photosensitive layer is provided on a surface of the blocking layer in a thin film shape or a thick film shape (Fig. 4 to Fig. 6), an aspect in which the photosensitive layer is provided on a surface of the electron transport layer in a thin film shape or a thick film shape, and the like. The photosensitive layer may be provided in a linear shape or in a dispersed pattern, but is preferably provided in a film shape.

The particle-containing layer is provided on the first electrode through another layer, and preferably in adjacent to the following charge transport layer. The particle-containing layer is a layer that contains conductive fine particles and a polymer, and is formed to transport charges at least in a thickness direction of the layer. The particle-containing layer may be a single layer or multilayers.

In the invention, the particle-containing layer is a layer that contains conductive fine particles and a polymer. The particle-containing layer includes a mixed layer. In the mixed layer, a region, in which the conductive fine particles and the polymer are preferably densely mixed with each other, expands in a layered shape. In the particle-containing layer, the conductive fine particles and the polymer may be contained (mixed) in any state as long as the mixed layer is included. For example, a part of a layer surface constituted by the conductive fine particles may be covered with the polymer.

The particle-containing layer and the mixed layer may include a region in which the polymer and the conductive fine particles are not mixed. This region may be dispersed in the particle-containing layer in a certain extent not deteriorating a function of the mixed layer, or may be concentrated in a thickness direction of the particle-containing layer to form a fine particle layer constituted by fine particles.

Examples of the particle-containing layer having a single-layer structure include a mixed layer in which the conductive fine particles and the polymer are mixed as illustrated in Fig. 2 and Fig. 5. In the mixed layer, a gap between the conductive fine particles is filled with the polymer.

In addition, as illustrated in Fig. 1, Fig. 3, Fig. 4, and Fig. 6, examples of the particle-containing layer having a multi-layer structure include a layer that includes a mixed layer 4a that is provided at least on a photosensitive layer 13 side, preferably, in adjacent to a charge transport layer 3, and a fine particle layer 4b that is provided on a side opposite to the photosensitive layer 13 with the mixed layer 4a set as a reference and is constituted by conductive fine particles.

The charge transport layer is provided on the first electrode directly or through another layer, and preferably in adjacent to the first electrode. The charge transport layer is formed to transport charges at least in a thickness direction of the layer.

The charge transport layer is a layer that does not contain conductive fine particles. In the charge transport layer of the invention, "do not contain conductive fine particles" includes "contains conductive fine particles in a range in which a charge (hole) transporting function of the charge transport layer is not deteriorated". For example, a content rate of the conductive fine particles in the charge transport layer is set to 0% to 0.01% by mass.

As to be described later, the charge transport layer preferably contains a hole transporting material.

As described above, when the photoelectric conversion element includes the charge transport layer and the particle-containing layer on the first electrode in this order, a variation in initial photoelectric conversion efficiency becomes small, and it is also possible to reduce a variation in a deterioration amount of the photoelectric conversion efficiency after passage of a predetermined period.

When a CNT-containing layer that contains carbon nanotubes and the like is provided with respect to the photosensitive layer on a second electrode side, a deterioration factor such as water from the outside of the photoelectric

conversion element is blocked, and thus durability of the photoelectric conversion element is improved. On the other hand, in a case where the CNT-containing layer is simply formed on the photosensitive layer, a variation in the photoelectric conversion efficiency occurs. The reason for this is considered to be because the carbon nanotubes and the like penetrate through the CNT-containing layer (protrude from the CNT-containing layer), and thus reverse electron migration due to contact with a perovskite compound as the photosensitive layer, and the like occur. Particularly, it is considered that a state in which the carbon nanotubes and the like protrude from the CNT-containing layer, the frequency thereof, and the like are not constant.

However, in the invention, the conductive fine particles rather than the carbon nanotubes and the like are contained, and the charge transport layer is provided in the particle-containing layer, which contains the particles, on a photosensitive layer side. According to this, it is possible to prevent the conductive particles contained in the particle-containing layer and the photosensitive layer from coming into contact with each other. In addition, it is considered that the conductive fine particles do not protrude from the particle-containing layer and stay in the particle-containing layer, and thus the contact is effectively prevented.

In the photoelectric conversion element of the invention, a configuration other than a configuration defined in the invention is not particularly limited, and it is possible to employ a configuration that is known with respect to the photoelectric conversion element and the solar cell. Respective layers, which constitute the photoelectric conversion element of the invention, are designed in accordance with the purposes thereof, and may be formed, for example, in a monolayer or multilayers.

Hereinafter, description will be given of preferred aspects of the photoelectric conversion element of the invention.

In Fig. 1 to Fig. 6, the same reference numeral represents the same constituent element (member).

In this specification, simple description of "photoelectric conversion element 10" represents photoelectric conversion elements 10A to 10F unless otherwise stated. This is also true of a system 100 and a first electrode 1. In addition, description of "first electrode 1" represents first electrodes 1A and 1B unless otherwise stated.

Examples of a preferred aspect of the photoelectric conversion element of the invention include the photoelectric conversion element 10A illustrated in Fig. 1. A system 100A illustrated in Fig. 1 is a system in which the photoelectric conversion element 10A is applied to a cell that allows operation means M (for example, an electric motor) to operate with an external circuit 6. The external circuit 6 is connected to a transparent electrode 11b of a conductive substrate 11 and a second electrode 2.

The photoelectric conversion element 10A includes a first electrode 1A, a second electrode 2 that is opposite to the first electrode 1A, and a charge transport layer 3 and a particle-containing layer 4 which are provided between the first electrode 1A and the second electrode 2 in this order from the first electrode 1A side.

The first electrode 1A includes a conductive support 11 that includes a support 11a and the transparent electrode 11b, a blocking layer 14 that is formed on the transparent electrode 11b, a porous layer 12 that is formed on the blocking layer 14, and a photosensitive layer 13 that is formed on a surface of the porous layer 12 and contains a perovskite-type light absorbing agent. In the photoelectric conversion element 10A that includes the porous layer 12, it is estimated that a surface area of the photosensitive layer 13 increases, and thus charge separation and charge migration efficiency are improved.

The charge transport layer 3 is formed on the first electrode 1A as a single layer.

The particle-containing layer 4 is formed on the charge transport layer 3 in a two-layer structure. The two-layer structure of the particle-containing layer 4 includes a mixed layer 4a on the charge transport layer 3, and a fine particle layer 4b on the mixed layer 4a.

The photoelectric conversion element 10B illustrated in Fig. 2 schematically illustrates a preferred aspect in which the particle-containing layer 4 of the photoelectric conversion element 10A illustrated in Fig. 1 is set as a single layer structure. The photoelectric conversion element 10B is different from the photoelectric conversion element 10A illustrated in Fig. 1 in that the particle-containing layer 4 is constituted by the mixed layer 4a, but has the same configuration as that of the photoelectric conversion element 10A except for the difference.

The photoelectric conversion element 10C illustrated in Fig. 3 schematically illustrates another preferred aspect of the photoelectric conversion element of the invention. The photoelectric conversion element 10C is different from the photoelectric conversion element 10A illustrated in Fig. 1 in that the second electrode 2 is not provided, but has the same configuration as that of the photoelectric conversion element 10A except for the difference. That is, in the photoelectric conversion element 10C, the particle-containing layer 4, particularly, the fine particle layer 4b thereof also functions as the second electrode 2.

The photoelectric conversion element 10D illustrated in Fig. 4 schematically illustrates still another preferred aspect of the photoelectric conversion element of the invention. The photoelectric conversion element 10D is different from the photoelectric conversion element 10A illustrated in Fig. 1 in that the porous layer 12 is not provided, but has the same configuration as that of the photoelectric conversion element 10A except for the difference. The first electrode 1B includes the conductive support 11, and the blocking layer 14 and the photosensitive layer 13 which are sequentially

formed on the conductive support 11.

The photoelectric conversion element 10E illustrated in Fig. 5 schematically illustrates still another preferred aspect of the photoelectric conversion element of the invention. The photoelectric conversion element 10E is different from the photoelectric conversion element 10B illustrated in Fig. 2 in that the porous layer 12 is not provided, but has the same configuration as that of the photoelectric conversion element 10B except for the difference. A first electrode 1B is the same as the first electrode 1B of the photoelectric conversion element 10D.

The photoelectric conversion element 10F illustrated in Fig. 6 schematically illustrates still another preferred aspect of the photoelectric conversion element of the invention. The photoelectric conversion element 10F is different from the photoelectric conversion element 10C illustrated in Fig. 3 in that the porous layer 12 is not provided, but has the same configuration as that of the photoelectric conversion element 10C except for the difference. A first electrode 1B is the same as the first electrode 1B of the photoelectric conversion element 10D.

In the invention, a system 100 to which the photoelectric conversion element 10 is applied functions as a solar cell in the following manner.

Specifically, in the photoelectric conversion element 10, light that is transmitted through the conductive support 11, or light that is transmitted through the second electrode 2 (or the mixed layer 4a) and is incident to the photosensitive layer 13 excites a light absorbing agent. The excited light absorbing agent includes high-energy electrons and can emit the electrons. The light absorbing agent, which emits high-energy electrons, becomes an oxidized substance (cation).

In the photoelectric conversion elements 10, electrons emitted from the light absorbing agent migrate between a plurality of the light absorbing agents and reach the conductive support 11. The electrons which have reached the conductive support 11 do work in the external circuit 6, and then return to the photosensitive layer 13 through the second electrode 2 (in a case where the second electrode 2 is provided) and subsequently through the particle-containing layer 4 and the charge transport layer 3. The light absorbing agent is reduced by the electrons which have returned to the photosensitive layer 13.

In the photoelectric conversion element 10, a cycle of excitation of the light absorbing agent and electron migration is repeated, and thus the system 100 functions as a solar cell.

In the photoelectric conversion element 10, a method of allowing an electron to flow from the photosensitive layer 13 to the conductive support 11 is different depending on presence or absence of the porous layer 12, a kind thereof, and the like. In the photoelectric conversion element 10 of the invention, electron conduction, in which electrons migrate between the light absorbing agents, occurs. Accordingly, in a case where the porous layer 12 is provided, the porous layer 12 can be formed from an insulating substance other than semiconductors in the related art. Accordingly, in a case where the porous layer 12 is formed from a semiconductor, electron conduction, in which electrons migrate at the inside of semiconductor fine particles of the porous layer 12 or between the semiconductor fine particles, also occurs. On the other hand, in a case where the porous layer 12 is formed from an insulating substance, electron conduction in the porous layer 12 does not occur. In a case where the porous layer 12 is formed from the insulating substance, when using an aluminum oxide ($Al_2O_3$) as the fine particles of the insulating substance, a relatively high electromotive force ($V_{oc}$) is obtained.

Even in a case where the blocking layer 14 as the other layer is formed from a conductor or a semiconductor, electron conduction in the blocking layer 14 occurs.

The photoelectric conversion element and the solar cell of the invention are not limited to the preferred aspects, and configurations and the like of the respective aspects may be appropriately combined between the respective aspects in a range not departing from the gist of the invention.

In the invention, materials and respective members which are used in the photoelectric conversion element and the solar cell can be prepared by using a typical method except for the light absorbing agent. With regard to a photoelectric conversion element or a solar cell in which a perovskite compound is used, for example, reference can be made to Science, 2012, vol. 338, p. 643 to 647, Nano lett, 2014, 14, p. 5561 to 5568, and J. Am. Chem. Soc., 2009, 131(17), p. 6050 to6051.

In addition, reference can be made to materials and respective members which are used in a dye sensitized solar cell. With regard to dye sensitized solar cells, for example, reference can be made to JP2001-291534A, US4,927,721A, US4,684,537A, US5,084,365A, US5,350,644A, US5,463,057A, US5,525,440A, JP1995-249790A (JP-H7-249790A), JP2004-220974A, and JP2008-135197A.

Hereinafter, description will be given of members and compounds which are appropriately used in the photoelectric conversion element and the solar cell of the invention.

<First Electrode 1>

The first electrode 1 includes the conductive support 11 and the photosensitive layer 13, and functions as a working electrode in the photoelectric conversion element 10.

As illustrated in Fig. 1 to Fig. 6, it is preferable that the first electrode 1 includes at least one of the porous layer

12 or the blocking layer 14.

It is preferable that the first electrode 1 includes at least the blocking layer 14 from the viewpoint of short-circuit prevention, and more preferably the porous layer 12 and the blocking layer 14 from the viewpoints of light absorption efficiency and short-circuit prevention.

In addition, it is preferable that the first electrode 1 includes the electron transport layer formed from an organic material from the viewpoints of an improvement in productivity of the photoelectric conversion element, thickness reduction, and flexibilization.

- Conductive Support 11 -

The conductive support 11 is not particularly limited as long as the conductive support 11 has conductivity and can support the photosensitive layer 13 and the like. It is preferable that the conductive support 11 has a configuration formed from a conductive material, for example, a metal, or a configuration including the support 11a formed from glass or plastic and the transparent electrode 11b formed on a surface of the support 11a as a conductive film. In a case where the strength of the conductive support 11 is sufficiently maintained, the support 11a is not necessary.

Among these, as illustrated in Fig. 1 to Fig. 6, it is more preferable that the conductive support 11 has a configuration in which a conductive metal oxide is applied to the surface of the support 11a formed from glass or plastic to form the transparent electrode 11b. Examples of the support 11a formed from plastic include a transparent polymer film described in Paragraph 0153 of JP2001-291534A. As a material that forms the support 11a, it is possible to use ceramic (JP2005-135902A) and a conductive resin (JP2001-160425A) in addition to glass or plastic. As a metal oxide, a tin oxide (TO) is preferable, and an indium-tin oxide (a tin-doped indium oxide; ITO) or a fluorine-doped tin oxide such as a fluorine-doped tin oxide (FTO) more preferable. At this time, the amount of the metal oxide applied is preferably 0.1 to 100 g per square meter of a surface area of the support 11a. In a case of using the conductive support 11, it is preferable that light is incident from a support 11a side.

It is preferable that the conductive support 11 is substantially transparent. In the invention, "substantially transparent" represents that transmittance of light (having a wavelength of 300 to 1200 nm) is 10% or greater, preferably 50% or greater, and more preferably 80% or greater.

The thickness of the support 11a and the conductive support 11 is not particularly limited and is set to an appropriate thickness. For example, the thickness is preferably 0.01 μm to 10 mm, more preferably 0.1 μm to 5 mm, and still preferably 0.3 μm to 4 mm.

In a case of providing the transparent electrode 11b, the film thickness of the transparent electrode 11b is not particularly limited. For example, the film thickness is preferably 0.01 to 30 μm, more preferably 0.03 to 25 μm, and still more preferably 0.05 to 20 μm.

The conductive support 11 or the support 11a may have a light management function on the surface. For example, the conductive support 11 or the support 11a may include an antireflection film formed by alternately laminating a high-refractive-index film and a low-refractive-index oxide film on the surface of the conductive support 11 or the support 11a as described in JP2003-123859A or may have a light guide function as described in JP2002-260746A.

- Blocking Layer 14 -

In the invention, as in the photoelectric conversion element 10, the blocking layer 14 is preferably provided on the surface of the transparent electrode 11b, that is, between the conductive support 11, and the porous layer 12, the photosensitive layer 13, or the like.

In the photoelectric conversion element and the solar cell, for example, when the photosensitive layer 13, the transparent electrode 11b, and the like are electrically connected to each other, a reverse current is generated. The blocking layer 14 plays a role of preventing the reverse current. The blocking layer 14 is also referred to as a "short-circuit prevention layer".

The blocking layer 14 may be allowed to function as a stage that carries the light absorbing agent.

The blocking layer 14 may be provided even in a case where the photoelectric conversion element includes the electron transport layer. In this case, the blocking layer 14 is provided between the conductive support and the electron transport layer.

The material that forms the blocking layer 14 is not particularly limited as long as the material can perform the above-described function, and it is preferable that the material is a material through which visible light is transmitted, and which has insulating properties with respect to the conductive support 11 (transparent electrode 11b) and the like. Specifically, "material having insulating properties with respect to the conductive support 11 (transparent electrode 11b)" represents a compound (n-type semiconductor compound) having a conduction band energy level that is equal to or higher than a conduction band energy level of a material that forms the conductive support 11 (a metal oxide that forms the transparent electrode 11b) and is lower than a conduction band energy level of a material that constitutes the porous

layer 12 or a ground state energy level of the light absorbing agent.

Examples of a material that forms the blocking layer 14 include silicon oxide, magnesium oxide, aluminum oxide, calcium carbonate, cesium carbonate, polyvinyl alcohol, polyurethane, and the like. In addition, the material may be a material that is typically used as a photoelectric conversion material, and examples thereof include titanium oxide, tin oxide, zinc oxide, niobium oxide, tungsten oxide, and the like. Among these, titanium oxide, tin oxide, magnesium oxide, aluminum oxide, and the like are preferred.

It is preferable that the film thickness of the blocking layer 14 is 0.001 to 10 μm, more preferably 0.005 to 1 μm, and still more preferably 0.01 to 0.1 μm.

In the invention, the film thicknesses of the respective layers can be measured by observing a cross-section of the photoelectric conversion element 10 by using a scanning electron microscope (SEM) and the like.

- Porous Layer 12 -

In the invention, as in the photoelectric conversion elements 10A to 10C, the porous layer 12 is preferably provided on the transparent electrode 11b. In a case where the blocking layer 14 is provided, the porous layer 12 is preferably formed on the blocking layer 14.

The porous layer 12 is a layer that functions as a stage that carries the photosensitive layer 13 on the surface. In a solar cell, so as to increase the light absorption efficiency, it is preferable to increase a surface area of at least a portion that receives light such as solar light, and it is more preferable to increase the surface area of the porous layer 12 as a whole.

It is preferable that the porous layer 12 is a fine particle layer that includes pores and is formed through vapor deposition or close contact of fine particles of a material that forms the porous layer 12. The porous layer 12 may be a fine particle layer that is formed through vapor deposition of two or more kinds of fine particles. In a case where the porous layer 12 is a fine particle layer that includes pores, it is possible to increase the amount (adsorption amount) of the light absorbing agent carried.

It is preferable to increase the surface area of individual fine particles which constitute the porous layer 12 so as to increase the surface area of the porous layer 12. In the invention, in a state in which the fine particles are applied to the conductive support 11 and the like, it is preferable that the surface area of the fine particles which form the porous layer 12 is 10 or more times a projected area, and more preferably 100 or more times the projected area. The upper limit thereof is not particularly limited. Typically, the upper limit is approximately 5000 times the projected area. With regard to a particle size of the fine particles which form the porous layer 12, an average particle size, which uses a diameter when converting the projected area into a circle, is preferably 0.001 to 1 μm as primary particles. In a case where the porous layer 12 is formed by using a dispersion of fine particles, the average particle size of the fine particles is preferably 0.01 to 100 μm in terms of an average particle size of the dispersion.

For the material that forms the porous layer 12, there is no particular limitation with respect to conductivity. The material may be an insulating substance (insulating material), a conductive material, or a semiconductor (semi-conductive material).

As the material that forms the porous layer 12, it is possible to use, for example, chalcogenides (for example, an oxide, a sulfide, a selenide, and the like) of metals, compounds having a perovskite-type crystal structure (excluding a perovskite compound that uses a light absorbing agent), oxides of silicon (for example, silicon dioxide, and zeolite), or carbon nanotubes (including carbon nanowires, carbon nanorods, and the like).

The chalcogenides of a metal are not particularly limited, and preferred examples thereof include respective oxides of titanium, tin, zinc, tungsten, zirconium, hafnium, strontium, indium, cerium, yttrium, lanthanum, vanadium, niobium, aluminum, and tantalum, cadmium sulfide, cadmium selenide, and the like. Examples of the crystal structure of the chalcogenides of metals include an anatase-type crystal structure, a brookite-type crystal structure, and a rutile-type crystal structure, and the anatase-type crystal structure and the brookite-type crystal structure are preferable.

The compound having a perovskite-type crystal structure is not particularly limited, and examples thereof include a transition metal oxide and the like. Examples of the transition metal oxide include strontium titanate, calcium titanate, barium titanate, lead titanate, barium zirconate, barium stannate, lead zirconate, strontium zirconate, strontium tantalate, potassium niobate, bismuth ferrate, barium strontium titanate, lanthanum barium titanate, calcium titanate, sodium titanate, and bismuth titanate. Among these, strontium titanate, calcium titanate, and the like are preferable.

The carbon nanotubes have a shape obtained by rounding off a carbon film (graphene sheet) into a tubular shape. The carbon nanotubes are classified into a single-walled carbon nanotube (SWCNT) obtained by winding one graphene sheet in a cylindrical shape, a double-walled carbon nanotube (DWCNT) obtained by winding two graphene sheets in a concentric shape, and a multi-walled carbon nanotube (MWCNT) obtained by winding a plurality of graphene sheets in a concentric shape. As the porous layer 12, any carbon nanotubes can be used without any particular limitation.

Among these, as the material that forms the porous layer 12, an oxide of titanium, tin, zinc, zirconium, aluminum, or silicon, or a carbon nanotube is preferable, and titanium oxide or aluminum oxide is more preferable.

The porous layer 12 may be formed from at least one kind of the chalcogenides of metals, the compound having a perovskite-type crystal structure, the oxide of silicon, or the carbon nanotube, or may be formed from a plurality of kinds thereof.

The film thickness of the porous layer 12 is not particularly limited. The thickness is typically in a range of 0.05 to 100 μm, and preferably in a range of 0.1 to 100 μm. In a case of being used as a solar cell, the film thickness is preferably 0.1 to 50 μm, and more preferably 0.2 to 30 μm.

- Electron Transport Layer -

In the invention, as described above, the electron transport layer may be provided on a surface of the transparent electrode 11b. The electron transport layer has a function of transporting electrons, which occur in the photosensitive layer 13, to the conductive support 11. The electron transport layer is formed from an electron transporting material capable of exhibiting the above-described function. The electron transporting material is not particularly limited, and an organic material (organic electron transporting material) is preferable. Examples of the organic electron transporting material include fullerene compounds such as [6,6]-phenyl-C61-butyric acid methyl ester ($PC_{61}BM$), perylene compounds such as perylene tetracarboxylic diimide (PTCDI), low-molecular-weight compounds such as tetracyanoquinodimethane (TCNQ), high-molecular-weight compounds, and the like. Although not particularly limited, it is preferable that the film thickness of the electron transport layer provided in the first electrode 1 is 0.001 to 10 μm, and more preferably 0.01 to 1 μm.

- Photosensitive Layer (Light Absorbing Layer) 13 -

The photosensitive layer 13 is preferably provided on the surface (including an inner surface of a concave portion in a case where a surface on which the photosensitive layer 13 is provided is uneven) of each of the porous layer 12 (in the photoelectric conversion elements 10A to 10C), the blocking layer 14 (in the photoelectric conversion elements 10D to 10F), and the electron transport layer.

In the invention, the perovskite-type light absorbing agent may contain at least one kind of specific perovskite compound to be described later, or two or more kinds of perovskite compounds.

In addition, the photosensitive layer 13 may include a light absorbing agent other than the perovskite compound in combination with the perovskite-type light absorbing agent. Examples of the light absorbing agent other than the perovskite compound include a metal complex dye, and an organic dye. At this time, a ratio between the perovskite-type light absorbing agent and the light absorbing agent other than the perovskite-type light absorbing agent is not particularly limited.

The photosensitive layer 13 may be a monolayer or a laminated layer of two or more layers. In a case where the photosensitive layer 13 has the laminated layer structure of two or more layers, the laminated layer structure may be a laminated layer structure obtained by laminating layers formed from light absorbing agents different from each other, or a laminated layer structure including an interlayer including a hole transporting material between a photosensitive layer and a photosensitive layer.

The aspect in which the photosensitive layer 13 is provided on the conductive support 11 is as described above. The photosensitive layer 13 is preferably provided on a surface of each of the layers in order for an excited electron to flow to the conductive support 11. At this time, the photosensitive layer 13 may be provided on the entirety or a part of the surface of each of the layers.

The film thickness of the photosensitive layer 13 is appropriately set in correspondence with an aspect in which the photosensitive layer 13 is provided on the conductive support 11, and is not particularly limited. Typically, for example, the film thickness is preferably 0.001 to 100 μm, more preferably 0.01 to 10 μm, and still more preferably 0.01 to 5 μm.

In a case where the porous layer 12 is provided, a total film thickness including the film thickness of the porous layer 12 is preferably 0.01 μm or greater, more preferably 0.05 μm or greater, still more preferably 0.1 μm or greater, and still more preferably 0.3 μm or greater. In addition, the total film thickness is preferably 100 μm or less, more preferably 50 μm or less, and still more preferably 30 μm or less. The total film thickness may be set to a range in which the above-described values are appropriately combined.

In the invention, in a case where the first electrode includes the porous layer 12 and the hole transport layer, a total film thickness of the porous layer 12, the photosensitive layer 13, and the hole transport layer is not particularly limited. For example, the total thickness is preferably 0.01 μm or greater, more preferably 0.05 μm or greater, still more preferably 0.1 μm or greater, and still more preferably 0.3 μm or greater. In addition, the total film thickness is preferably 200 μm or less, more preferably 50 μm or less, still more preferably 30 μm or less, and still more preferably 5 μm or less. The total film thickness can be set to a range in which the above-described values are appropriately combined.

In the invention, in a case where the photosensitive layer is provided in a thick film shape, the light absorbing agent that is included in the photosensitive layer may function as a hole transporting material.

The amount of the perovskite compound used is preferably set to an amount capable of covering at least a

part of a surface of the first electrode 1, and more preferably an amount capable of covering the entirety of the surface.

[Perovskite-Type Light Absorbing Agent]

The photosensitive layer 13 contains a perovskite compound that includes "an element of Group 1 in the periodic table or an cationic organic group A", "a metal atom M other than elements of Group 1 in the periodic table", and "an anionic atom or atomic group X" as the perovskite-type light absorbing agent.

In the perovskite compound, the element of Group 1 in the periodic table or the cationic organic group A, and the metal atom M or the anionic atom or atomic group X exists as individual constituent ions of a cation (for convenience, may be referred to as "cation A") and a metal cation (for convenience, may be referred to as "cation M") and an anion (for convenience, may be referred to as "anion X") in the perovskite-type crystal structure.

In the invention, the cationic organic group represents an organic group having a property of becoming a cation in the perovskite-type crystal structure, and the anionic atom or atomic group represents an atom or atomic group that has a property of becoming an anion in the perovskite-type crystal structure.

In the perovskite compound that is used in the invention, the cation A represents a cation of an element of Group 1 in the periodic table or an organic cation that is composed of a cationic organic group A. The cation A is preferably an organic cation.

The cation of an element of Group 1 in the periodic table is not particularly limited, and examples thereof include cations ($Li^+$, $Na^+$, $K^+$, and $Cs^+$) of individual elements of lithium (Li), sodium (Na), potassium (K), and cesium (Cs), and the cation ($Cs^+$) of cesium is more preferable.

The organic cation is not particularly limited as long as the organic cation is a cation of an organic group having the above-described property, but an organic cation of a cationic organic group represented by the following Formula (1) is more preferable.

Formula (1) : $R^{1a}-NH_3$

In Formula (1), $R^{1a}$ represents a substituent group. $R^{1a}$ is not particularly limited as long as $R^{1a}$ is an organic group, but an alkyl group, a cycloalkyl group, an alkenyl group, an alkynyl group, an aryl group, a heteroaryl group, or a group represented by the following Formula (2) is preferable. Among these, the alkyl group and a group represented by the following Formula (2) are more preferable.

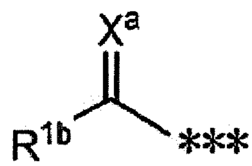

Formula (2)

In Formula (2), $X^a$ represents $NR^{1c}$, an oxygen atom, or a sulfur atom. $R^{1b}$ and $R^{1c}$ each independently represent a hydrogen atom or a substituent group. *** represents bonding with a nitrogen atom in Formula (1).

In the invention, as the organic cation of the cationic organic group A, an organic ammonium cation ($R^{1a}-NH_3^+$) composed of an ammonium cationic organic group A obtained through bonding between $R^{1a}$ and $NH_3$ in Formula (1) is preferable. In a case where the organic ammonium cation can employ a resonance structure, the organic cation further includes a cation having the resonance structure in addition to the organic ammonium cation. For example, in a case where $X^a$ is NH ($R^{1c}$ is a hydrogen atom) in a group represented by Formula (2), the organic cation also includes an organic amidinium cation that is one of a resonance structure of the organic ammonium cation in addition to the organic ammonium cation of the ammonium cationic organic group obtained through bonding between the group represented by Formula (2) and $NH_3$. Examples of the organic amidinium cation composed of the amidinium cationic organic group include a cation represented by the following Formula ($A^{am}$). In this specification, the cation represented by the following Formula ($A^{am}$) may be noted as "$R^{1b}C(=NH)-NH_{3+}$" for convenience.

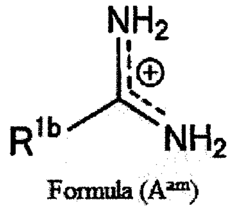

Formula ($A^{am}$)

The alkyl group is preferably an alkyl group having 1 to 18 carbon atoms, more preferably an alkyl group having 1 to 6 carbon atoms, and still more preferably an alkyl group having 1 to 3 carbon atoms. Examples of the alkyl group include methyl, ethyl, propyl, isopropyl, butyl, tert-butyl, pentyl, hexyl, and the like.

The cycloalkyl group is preferably a cycloalkyl group having 3 to 8 carbon atoms, and examples thereof include cyclopropyl, cyclopentyl, cyclohexyl, and the like.

The alkenyl group is preferably an alkenyl group having 2 to 18 carbon atoms, and more preferably an alkenyl group having 2 to 6 carbon atoms. Examples of the alkenyl group include vinyl, allyl, butenyl, hexenyl, and the like.

The alkynyl group is preferably an alkynyl group having 2 to 18 carbon atoms, and more preferably an alkynyl group having 2 to 4 carbon atoms. Examples of the alkynyl group include ethynyl, butynyl, hexynyl, and the like.

The aryl group is preferably an aryl group having 6 to 14 carbon atoms, and more preferably an aryl group having 6 to 12 carbon atoms, and examples thereof include phenyl.

The heteroaryl group includes a group composed of an aromatic hetero ring alone, and a group composed of a condensed hetero ring obtained through condensing of another ring, for example, an aromatic ring, an aliphatic ring, or a hetero ring with the aromatic hetero ring.

As the ring-constituting hetero atom that constitutes the aromatic hetero ring, a nitrogen atom, an oxygen atom, or a sulfur atom is preferable. In addition, with regard to the number of ring members of the aromatic hetero ring, three-membered to eight-membered rings are preferable, and a five-membered ring or a six-membered ring is more preferable.

Examples of the five-membered aromatic hetero ring and the condensed hetero ring including the five-membered aromatic hetero ring include respective cyclic groups of a pyrrole ring, an imidazole ring, a pyrazole ring, an oxazole ring, a thiazole ring, a triazole ring, a furan ring, a thiophene ring, a benzimidazole ring, a benzoxazole ring, a benzothiazole ring, an indoline ring, and an indazole ring. In addition, examples of the six-membered aromatic hetero ring and the condensed hetero ring including the six-membered aromatic hetero ring include respective cyclic groups of a pyridine ring, a pyrimidine ring, a pyrazine ring, a triazine ring, a quinoline ring, and a quinazoline ring.

In the group represented by Formula (2), $X^a$ represents $NR^{1c}$, an oxygen atom, or a sulfur atom, and $NR^{1c}$ is preferable as $X^a$. Here, $R^{1c}$ represents a hydrogen atom or a substituent group. $R^{1c}$ is preferably a hydrogen atom, an alkyl group, a cycloalkyl group, an alkenyl group, an alkynyl group, an aryl group, or a heteroaryl group, and more preferably a hydrogen atom.

$R^{1b}$ represents a hydrogen atom or a substituent group, and is preferably a hydrogen atom. Examples of the substituent group that can be employed as $R^{1b}$ include an amino group, an alkyl group, a cycloalkyl group, an alkenyl group, an alkynyl group, an aryl group, and a heteroaryl group.

An alkyl group, a cycloalkyl group, an alkenyl group, an alkynyl group, an aryl group, and a heteroaryl group that can be respectively employed by $R^{1b}$ and $R^{1c}$ are the same as the respective groups of $R^{1a}$, and preferred examples thereof are the same as described above.

Examples of the group represented by Formula (2) include a (thio)acyl group, a (thio)carbamoyl group, an imidoyl group, and an amidino group.

Examples of the (thio)acyl group include an acyl group and a thioacyl group. The acyl group is preferably an acyl group having a total of 1 to 7 carbon atoms, and examples thereof include formyl, acetyl ($CH_3C(=O)-$), propionyl, hexanoyl, and the like. The thioacyl group is preferably a thioacyl group having a total of 1 to 7 carbon atoms, and examples thereof include thioformyl, thioacetyl ($CH_3C(=S)-$), thiopropionyl, and the like.

Examples of the (thio)carbamoyl group include a carbamoyl group ($H_2NC(=O)-$) and a thiocarbamoyl group ($H_2NC(=S)-$).

The imidoyl group is a group represented by $R^{1b}-C(=NR^{1c})-$, and it is preferable that $R^{1b}$ and $R^{1c}$ are respectively a hydrogen atom and an alkyl group. More preferably, the alkyl group is the same as the alkyl group as $R^{1a}$. Examples thereof include formimidoyl ($HC(=NH)-$), acetoimidoyl ($CH_3C(=NH)-$), propionimidoyl ($CH_3CH_2C(=NH)-$), and the like. Among these, formimidoyl is preferable.

The amidino group as the group represented by Formula (2) has a structure ($-C(=NH)NH_2$) in which $R^{1b}$ of the imidoyl group is an amino group and $R^{1c}$ is a hydrogen atom.

The entirety of the alkyl group, the cycloalkyl group, the alkenyl group, the alkynyl group, the aryl group, the heteroaryl group, and the group represented by Formula (2), which can be employed as $R^{1a}$, may have a substituent group. The substituent group, which $R^{1a}$ may have, is not particularly limited, and examples thereof include an alkyl

group, a cycloalkyl group, an alkenyl group, an alkynyl group, an aryl group, a heterocyclic group, an alkoxy group, an alkylthio group, an amino group, an alkylamino group, an arylamino group, an acyl group, an alkylcarbonyloxy group, an aryloxy group, an alkoxycarbonyl group, an aryloxycarbonyl group, an acylamino group, a sulfonamido group, a carbamoyl group, a sulfamoyl group, a halogen atom, a cyano group, a hydroxy group, and a carboxy group. The substituent group, which $R^{1a}$ may have, may be additionally substituted with a substituent group.

In the perovskite compound that is used in the invention, the metal cation M is not particularly limited as long as the metal cation M is a cation of a metal atom other than elements of Group 1 in the periodic table and is a cation of a metal atom that can employ the perovskite-type crystal structure. Examples of the metal atom include metal atoms such as calcium (Ca), strontium (Sr), cadmium (Cd), copper (Cu), nickel (Ni), manganese (Mn), iron (Fe), cobalt (Co), palladium (Pd), germanium (Ge), tin (Sn), lead (Pb), ytterbium (Yb), europium (Eu), indium (In), titanium (Ti), and bismuth (Bi). M may be one kind of metal cation, or two or more kinds of metal cations. Among these, the metal cation M is preferably a divalent cation, more preferably at least one kind selected from the group consisting of a divalent lead cation ($Pb^{2+}$), a divalent copper cation ($Cu^{2+}$), a divalent germanium cation ($Ge^{2+}$), and a divalent tin cation ($Sn^{2+}$), still more preferably $Pb^{2+}$ or $Sn^{2+}$, and still more preferably $Pb^{2+}$. In a case of two or more kinds of metal cations, a ratio of the metal cations is not particularly limited.

In the perovskite compound that is used in the invention, the anion X represents an anion of an anionic atom or atomic group X. Preferred examples of the anion include anions of halogen atoms, and anions of individual atomic groups of $NC^-$, $NCS^-$, $NCO^-$, $HO^-$, $NO_3^-$, $CH_3COO^-$, and $HCOO^-$. Among these, the anions of halogen atoms are more preferable. Examples of the halogen atoms include a fluorine atom, a chlorine atom, a bromine atom, an iodine atom, and the like.

The anion X may be an anion of one kind of anionic atom or atomic group, or anions of two or more kinds of anionic atoms or atomic groups. In a case where the anion X is an anion of one kind of anionic atom or atomic group, an anion of an iodine atom is preferable. On the other hand, in a case where the anion X includes anions of two or more kinds of anionic atoms or atomic groups, anions of two kinds of halogen atoms, particularly, an anion of a chlorine atom and an anion of an iodine atom are preferable. A ratio between two or more kinds of anions is not particularly limited.

As the perovskite compound that is used in the invention, a perovskite compound, which has a perovskite-type crystal structure including the above-described constituent ions and is represented by the following Formula (I), is preferable.

Formula (I) : $A_aM_mX_x$

In Formula (I), A represents an element of Group 1 in the periodic table or a cationic organic group. M represents a metal atom other than elements of Group 1 in the periodic table. X represents an anionic atom or atomic group.
a represents 1 or 2, m represents 1, and a, m, and x satisfy a relationship of a+2m=x.

In Formula (I), the element of Group 1 in the periodic table or the cationic organic group A forms the cation A of the perovskite-type crystal structure. Accordingly, there is no particular limitation as long as the element of Group 1 in the periodic table and the cationic organic group A are elements or groups which become the cation A and can constitute the perovskite-type crystal structure. The element of Group 1 in the periodic table or the cationic organic group A is the same as the element of Group 1 in the periodic table or the cationic organic group which is described in the above-described cation A, and preferred examples thereof are the same as described above.

The metal atom M is a metal atom that forms the metal cation M of the perovskite-type crystal structure. Accordingly, the metal atom M is not particularly limited as long as the metal atom M is an atom other than elements of Group 1 in the periodic table, becomes the metal cation M, and can form the perovskite-type crystal structure. The metal atom M is the same as the metal atom described in the above-described metal cation M, and preferred examples thereof are the same as described above.

The anionic atom or atomic group X forms the anion X of the perovskite-type crystal structure. Accordingly, the anionic atom or atomic group X is not particularly limited as long as the anionic atom or atomic group X is an atom or atomic group that becomes the anion X and can constitute the perovskite-type crystal structure. The anionic atom or atomic group X is the same as the anionic atom or atomic group which is described in the above-described anion X, and preferred examples thereof are the same as described above.

The perovskite compound represented by Formula (I) is a perovskite compound represented by the following Formula (I-1) in a case where a is 1, or a perovskite compound represented by the following Formula (I-2) in a case where a is 2.

Formula (I-1) : $AMX_3$

Formula (1-2) : $A_2MX_4$

In Formula (I-1) and Formula (1-2), A represents an element of Group 1 in the periodic table or a cationic organic group. A is the same as A in Formula (I), and preferred examples thereof are the same as described above.

M represents a metal atom other than elements of Group 1 in the periodic table. M is the same as M in Formula (I), and preferred examples thereof are the same as described above.

X represents an anionic atom or atomic group. X is the same as X in Formula (I), and preferred examples thereof are the same as described above.

The perovskite compound that is used in the invention may be any one of the compound represented by Formula (1-1) and the compound represented by Formula (1-2), or a mixture thereof. Accordingly, in the invention, at least one kind of the perovskite compound may exist as the light absorbing agent, and there is no need for clear and strict distinction on that the perovskite compound is which compound by using a composition formula, a molecular formula, a crystal structure, and the like.

Hereinafter, specific examples of the perovskite compound that can be used in the invention will be exemplified, but the invention is not limited to the specific examples. In the following description, the perovskite compound is classified into the compound represented by Formula (1-1) and the compound represented by Formula (1-2). However, even the compound exemplified as the compound represented by Formula (1-1) may be the compound represented by Formula (1-2) in accordance with synthesis conditions, or may be a mixture of the compound represented by Formula (I-1) and the compound represented by Formula (1-2). Similarly, even the compound exemplified as the compound represented by Formula (1-2) may be the compound represented by Formula (I-1), or may be a mixture of the compound represented by Formula (1-1) and the compound represented by Formula (1-2).

Specific examples of the compound represented by Formula (1-1) include $CH_3NH_3PbCl_3$, $CH_3NH_3PbBr_3$, $CH_3NH_3PbI_3$, $CH_3NH_3PbBrI_2$, $CH_3NH_3PbBr_2I$, $CH_3NH_3SnBr_3$, $CH_3NH_3SnI_3$, $CH_3NH_3GeCl_3$, $CH(=NH)NH_3PbI_3$, $CsSnI_3$, and $CsGeI_3$.

Specific examples of the compound represented by Formula (I-2) include $(C_2H_5NH_3)_2PbI_4$, $(C_{10}H_{21}NH_3)_2PbI_4$, $(CH_2{=}CHNH_3)_2PbI_4$, $(CH{\equiv}CNH_3)_2PbI_4$, $(n\text{-}C_3H_7NH_3)_2PbI_4$, $(n\text{-}C_4H_9NH_3)_2PbI_4$, $(C_6H_5NH_3)_2PbI_4$, $(C_6H_5CH_2CH_2NH_3)_2PbI_4$, $(C_6H_3F_2NH_3)_2PbI_4$, $(C_6F_5NH_3)_2PbI_4$, $(C_4H_3SNH_3)_2PbI_4$, $(CH_3NH_3)_2CuCl_4$, $(C_4H_9NH_3)_2GeI_4$, $(C_3H_7NH_3)_2FeBr_4$. Here, $C_4H_3SNH_3$ in $(C_4H_3SNH_3)_2PbI_4$ represents aminothiophene.

The perovskite compound can be synthesized from a compound represented by Formula (II) and a compound represented by Formula (III).

Formula (II) : AX

Formula (III) : $MX_2$

In Formula (II), A represents an element of Group 1 in the periodic table, or a cationic organic group. A is the same as A in Formula (I), and preferred examples thereof are the same as described above. In Formula (II), X represents an anionic atom or atomic group. X is the same as X in Formula (I), and preferred examples thereof are the same as described above.

In Formula (III), M represents a metal atom other than elements of Group 1 in the periodic table. M is the same as M in Formula (I), and preferred examples thereof are the same as described above. In Formula (III), X represents an anionic atom or atomic group. X is the same as X in Formula (I), and preferred examples thereof are the same as described above.

Examples of a method of synthesizing the perovskite compound include a method described in Science, 2012, vol. 338, p. 643 to 647 and Nano lett, 2014, 14, p. 5561-5568. Another example thereof also includes a method described in Akihiro Kojima, Kenjiro Teshima, Yasuo Shirai, and Tsutomu Miyasaka, "Organometal Halide Perovskites as Visible-Light Sensitizers for Photovoltaic Cells", J. Am. Chem. Soc., 2009, 131(17), p. 6050-6051.

The amount of the perovskite-type light absorbing agent used is preferably set to an amount capable of covering at least a part of the surface of the first electrode 1, and more preferably an amount capable of covering the entirety of the surface.

The amount of the perovskite compound contained in the photosensitive layer 13 is typically 1% to 100% by mass.

<Charge Transport Layer 3>

The photoelectric conversion element of the invention includes the charge transport layer 3 between the photosensitive layer 13 of the first electrode 1 and the particle-containing layer 4 to be described later. The charge transport layer 3 is preferably provided on a surface of the photosensitive layer 13. The charge transport layer 3 has a function of supplementing electrons to an oxidized substance of the light absorbing agent, and is preferably a solid-shaped layer (solid charge transport layer).

A material that forms the charge transport layer 3 is not particularly limited as long as the above-described

function is exhibited, and preferred examples thereof include a hole transporting material. The hole transporting material may be a liquid material or a solid material as long as these materials have a hole transporting function, or may be an inorganic material or an organic material without any particular limitation. Examples of the material include inorganic materials such as CuI and CuNCS, organic hole transporting materials described in Paragraphs 0209 to 0212 of JP2001-291534A, and the like. Preferred examples of the organic hole transporting material include conductive polymers such as polythiophene, polyaniline, polypyrrole, and polysilane, spiro compounds in which two rings share a central atom such as C or Si having a tetrahedral structure, aromatic amine compounds such as triarylamine, triphenylene compounds, nitrogen-containing heterocyclic compounds, and liquid-crystalline cyano compounds.

As the hole transporting material, an organic hole transporting material which can be applied in a solution state and then has a solid shape is preferable, and specific examples thereof include 2,2',7,7'-tetrakis-(N,N-di-p-methoxyphenylamino)-9,9'-spirobifluorene (spiro-MeOTAD), poly(3-hexylthiophene-2,5-diyl, P3HT), 4-(diethylamino)benzaldehyde diphenylhydrazone, polyethylene dioxythiophene (PEDOT), and the like.

In the invention, in a case where the charge transport layer is formed from the hole transporting material, the charge transport layer is also referred to as a hole transport layer.

As described above, the charge transport layer 3 does not contain conductive fine particles which are contained in the particle-containing layer 4. According to this, reverse electron migration is prevented between the particle-containing layer 4 and the photosensitive layer 13. As a result, it is possible to prevent a variation in photoelectric conversion efficiency and a variation in durability.

Although not particularly limited, the film thickness of the charge transport layer 3 is preferably 50 μm or less, more preferably 1 nm to 10 μm, still more preferably 5 nm to 5 μm, and still more preferably 10 nm to 1 μm.

<Particle-Containing Layer 4>

The photoelectric conversion element of the invention includes the particle-containing layer 4, which contains conductive fine particles and a polymer on the first electrode 1, preferably, on the charge transport layer 3. The particle-containing layer 4 has a function of transporting electrons, which flow from the second electrode 2 and the like, to the charge transport layer 3. A layer configuration of the particle-containing layer 4, and the like are as described above.

The conductive fine particles contained in the particle-containing layer 4 may be fine particles of a material having conductivity. The conductive material is not particularly limited, and examples thereof include a metal, a carbon material, a conductive polymer, a conductive metal oxide, and the like.

The carbon material may be a conductive material that is formed through bonding of carbon atoms, and examples thereof include fullerene, graphite, graphene, carbon black, and the like. Examples of the metal include various metals as materials which form the second electrode 2 to be described later. Examples of the conductive metal oxide include a metal oxide that forms the transparent electrode 11b.

Among these, the carbon material is preferable, and the carbon black is more preferable.

In the invention, the conductive fine particle represents a conductive particle in which an aspect ratio is preferably 100 or less, and more preferably 1 to 10. Conductivity is not particularly limited, but electrical resistivity (volume resistivity) as a measurement value by four-point probe method is $10^7$ Ω·cm or less.

A shape and dimensions (a particle size and a length) of the conductive fine particles are not particularly limited as long as the aspect ratio is preferably satisfied. For example, the shape may be a spherical shape, a granular shape, an amorphous shape, a rod shape, or a combination thereof.

In addition, the particle size and the length are also not particularly limited. An average particle size is typically 0.1 nm to 500 μm, preferably 1 nm to 100 μm more preferably 1 nm to 1 μm, and still more preferably 1 nm to 500 nm. Here, the average particle size is measured by using a SEM.

The polymer, which is contained in the particle-containing layer 4, may be an insulating material or a conductive material, but the insulating material is preferable. In the invention, although not particularly limited, the insulating material represents a material of which volume resistivity (Ω·cm) is greater than $10^7$. The volume resistivity is set to a measured value obtained by a four-probe method.

The polymer of the insulating material is not particularly limited, and examples thereof include polyethylene (PE), polypropylene (PP), polyvinyl chloride (PVC), polystyrene (PS), polyvinyl acetate (PVAc), polyurethane (PUR), polytetrafluoroethylene (PTEF), an acrylonitrile-butadiene-styrene copolymer resin (ABS), an acrylonitrile-styrene copolymer resin (AS), (meth)acrylic acid ester (particularly, polymethylmethacrylate (PMMA)), polyamide (PA), an acetal resin (polyoxymethylene, POM), polycarbonate (PC), a polyphenylene oxide resin (PPO), polyethylene terephthalate (PET), polybutylene terephthalate (PBT), a cycloolefin polymer (COP), polyphenylene sulfide (PPS), polysulfone (PSF) Polyethersulfone (PES), polyimide (PI), polyamideimide (PAI), and the like.

Among these, (meth)acrylic acid ester (particularly, polymethylmethacrylate (PMMA)), ABS, and PC are preferable.

Although not particularly limited, a weight-average molecular weight of the polymer of the insulating material

is preferably 1,000 to 1,000,000, more preferably 3,000 to 500,000, and still more preferably 5,000 to 300,000.

The weight-average molecular weight is a value that is measured as a standard polystyrene conversion value by gel permeation chromatography (GPC).

In the particle-containing layer 4, the amount of the conductive fine particles contained may be set to exhibit the function by the particle-containing layer 4, and cannot be uniquely determined in accordance with specific weight of the conductive fine particles and the polymer, dimensions of the conductive fine particles, and the like. As an example, the amount of the conductive fine particles contained in the particle-containing layer 4 is preferably 0.1% to 99.9% by mass, more preferably 1% to 99% by mass, and still more preferably 20% to 95% by mass.

Similarly, the amount of the polymer contained cannot be uniquely determined. However, the amount of the polymer contained in the particle-containing layer 4 is preferably 0.1% to 99.9% by mass, more preferably 1% to 99% by mass, and still more preferably 5% to 80% by mass.

In the particle-containing layer 4, a ratio of the amount of the conductive fine particles contained and the amount of the polymer contained cannot be uniquely determined. However, the ratio between the amounts [the amount of the conductive fine particles contained/the amount of the polymer contained] is preferably 999:1 to 1:999, more preferably 99:1 to 1:99, and still more preferably 19:1 to 1:4.

In the invention, it is possible to form the particle-containing layer 4 having a two-layer structure illustrated in Fig. 1 and the like in accordance with the respective amounts, and the ratio between the amounts. For example, when the amount of the conductive fine particles contained, and the ratio between the amounts are set to large values in the above-described ranges, it is possible to form the particle-containing layer 4 having a two-layer structure.

The film thickness of the particle-containing layer 4 is not particularly limited, and the film thickness is preferably 0.001 to 10 μm, more preferably 0.01 to 1 μm, and still more preferably 0.05 to 0.5 μm.

In a case where the particle-containing layer 4 includes the fine particle layer 4b, the film thickness of the fine particle layer 4b is not particularly limited, and the film thickness is preferably 0.001 to 1 μm, more preferably 0.005 to 0.5 μm, and still more preferably 0.01 to 0.1 μm.

<Second Electrode 2>

The second electrode 2 functions as a positive electrode or a negative electrode in a solar cell. The second electrode 2 is not particularly limited as long as the second electrode 2 has conductivity. Typically, the second electrode 2 can be configured to have the same configuration as that of the conductive support 11. In a case where sufficient strength is maintained, the support 11a is not necessary. In addition, it is also possible to use the particle-containing layer 4, particularly, the fine particle layer 4b as the second electrode 2 (the particle-containing layer 4 may be configured to also function as the second electrode 2).

As a structure of the second electrode 2, a structure having a high current-collection effect is preferable. At least one of the conductive support 11 or the second electrode 2 needs to be substantially transparent so that light reaches the photosensitive layer 13. In the solar cell of the invention, it is preferable that the conductive support 11 is transparent and solar light is incident from the support 11a side. In this case, it is more preferable that the second electrode 2 has a light-reflecting property.

Examples of a material used to form the second electrode 2 include metals such as platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al), the above-described conductive metal oxides, carbon materials, conductive polymers, and the like. Examples of the carbon materials include fullerene, a material that is described in the conductive fine particles, and a carbon nanotube.

In a case where the photoelectric conversion element 10 includes the particle-containing layer 4 and the second electrode 2, as the second electrode 2, a thin film (including a thin film formed through vapor deposition) of a metal or a conductive metal oxide, or a glass substrate or a plastic substrate which include the thin film is preferable. As the glass substrate or the plastic substrate, glass including a gold or platinum thin film or glass on which platinum is vapor-deposited is preferable.

On the other hand, in a case where the fine particle layer 4b also functions as the second electrode 2, as a material that forms the second electrode 2, carbon black or graphene among carbon materials is preferable.

The film thickness of the second electrode 2 is not particularly limited, and the thickness is preferably 0.01 to 100 μm, more preferably 0.01 to 10 μm, and still more preferably 0.01 to 1 μm.

<Other Configurations>

In the invention, a spacer or a separator can also be used instead of the blocking layer 14 and the like or in combination with the blocking layer 14 and the like so as to prevent the first electrode 1 and the second electrode 2 from coming into contact with each other.

In addition, a hole blocking layer may be provided between the second electrode 2 and the charge transport layer 3.

<<Solar Cell>>

The solar cell of the invention is constituted by using the photoelectric conversion element of the invention. For example, as illustrated in Fig. 1 to Fig. 6, the photoelectric conversion element 10 constituted by providing the external circuit 6 can be used as the solar cell. As the external circuit 6 that is connected to the first electrode 1 (the transparent electrode 11b) and the second electrode 2, a known circuit can be used without particular limitation.

For example, the invention is applicable to individual solar cells described in Science, 2012, vol. 338, p. 643 to 647, Nano lett, 2014, 14, p. 5561-5568, and J. Am. Chem. Soc., 2009, 131(17), p. 6050-6051.

It is preferable that a lateral surface of the solar cell of the invention is sealed with a polymer, an adhesive, and the like so as to prevent deterioration, evaporation, and the like in constituent substances.

As described above, the photoelectric conversion element and the solar cell of the invention include the charge transport layer and the particle-containing layer on the first electrode, and thus a variation in initial photoelectric conversion efficiency between elements, and a variation in a deterioration amount of photoelectric conversion efficiency after passage of a predetermined period (due to passage of time) are reduced.

<<Method of Manufacturing Photoelectric Conversion Element and Solar Cell>>

The photoelectric conversion element and the solar cell of the invention can be manufactured in accordance with a known method, for example, a method described in Science, 2012, vol. 338, p. 643 to 647, Nano lett, 2014, 14, p. 5561-5568, J. Am. Chem. Soc., 2009, 131(17), p. 6050-6051, and the like.

Hereinafter, the method of manufacturing the photoelectric conversion element and the solar cell of the invention will be described in brief.

In the manufacturing method of the invention, first, at least one of the blocking layer 14, the porous layer 12, or the electron transport layer is formed on a surface of the conductive support 11 in accordance with the purpose.

For example, the blocking layer 14 can be formed by a method in which a dispersion, which contains the insulating substance or a precursor compound thereof, and the like, is applied to the surface of the conductive support 11, and the dispersion is baked, a spray pyrolysis method, and the like.

A material that forms the porous layer 12 is preferably used as fine particles, and more preferably a dispersion that contains the fine particles.

A method of forming the porous layer 12 is not particularly limited, and examples thereof include a wet-type method, a dry-type method, and other methods (for example, a method described in Chemical Review, Vol. 110, p. 6595 (published on 2010)). In these methods, it is preferable that the dispersion (paste) is applied to the surface of the conductive support 11 or the surface of the blocking layer 14 and then the dispersion is baked at a temperature 100°C to 800°C for ten minutes to ten hours, for example, in the air. According to this, it is possible to bring the fine particles into close contact with each other.

In a case where baking is performed a plurality of times, a temperature in baking except final baking (a baking temperature except for a final baking temperature) is preferably set to be lower than the temperature in the final baking (the final baking temperature). For example, in a case where titanium oxide paste is used, the baking temperature except for the final baking temperature can be set in a range of 50°C to 300°C. In addition, the final baking temperature can be set in a range of 100°C to 600°C to be higher than the baking temperature except for the final baking temperature. In a case where a glass support is used as the support 11a, the baking temperature is preferably 60°C to 500°C.

The amount of a porous material applied to form the porous layer 12 is appropriately set in correspondence with the film thickness of the porous layer 12, the number of times of coating, and the like, and there is no particular limitation thereto. For example, the amount of the porous material applied per surface area 1 $m^2$ of the conductive support 11 is preferably 0.5 to 500 g, and more preferably 5 to 100 g.

In a case of providing the electron transport layer, the electron transport layer can be formed through application and drying of an electron transporting material solution that contains an electron transporting material.

Next, the photosensitive layer 13 is provided.

Examples of a method of providing the photosensitive layer 13 include a wet-type method and a dry-type method, and there is no particular limitation thereto. In the invention, the wet-type method is preferable, and for example, a method of bringing an arbitrary layer into contact with a light absorbing agent solution that contains a perovskite-type light absorbing agent is preferable. In the method, first, the light absorbing agent solution for forming the photosensitive layer is prepared. The light absorbing agent solution contains $MX_2$ and AX which are raw materials of the perovskite compound. Here, A, M, and X are the same as A, M, and X in Formula (I). In the light absorbing agent solution, a molar ratio between $MX_2$ and AX is appropriately adjusted in correspondence with the purpose. In a case of forming the

perovskite compound as the light absorbing agent, the molar ratio between AX and $MX_2$ is preferably 1:1 to 10:1. The light absorbing agent solution can be prepared by mixing $MX_2$ and AX in a predetermined molar ratio and, preferably, by heating the resultant mixture. The formation liquid is typically a solution, but may be a suspension. Heating conditions are not particularly limited. A heating temperature is preferably 30°C to 200°C, more preferably 60°C to 150°C, and still more preferably 70°C to 150°C. Heating time is preferably 0.5 to 100 hours, and more preferably 1 to 3 hours. As a solvent or a dispersion medium, the following solvent or dispersion medium can be used.

Then, the light absorbing agent solution, which is prepared, is brought into contact with a surface of a layer (in the photoelectric conversion element 10, a layer of any one of the porous layer 12, the blocking layer 14, and the electron transport layer) on which the photosensitive layer 13 is to be formed. Specifically, application of the light absorbing agent solution or immersion in the light absorbing agent solution is preferable. A contact temperature is preferably 5°C to 100°C, and immersion time is preferably 5 seconds to 24 hours and more preferably 20 seconds to 1 hour. In a case of drying the light absorbing agent solution that is applied, with regard to the drying, drying with heat is preferable, and drying is performed by heating the applied light absorbing agent solution typically at 20°C to 300°C, and preferably at 50°C to 170°C.

In addition, the photosensitive layer can also be formed in conformity to a method of synthesizing the perovskite compound.

In addition, another example of the method includes a method in which an AX solution that contains AX, and an $MX_2$ solution that contains $MX_2$ are individually applied (including an immersion method), and are dried as necessary. In this method, an arbitrary solution may be previously applied, but it is preferable that the $MX_2$ solution is previously applied. A molar ratio between AX and $MX_2$, application conditions, and drying conditions in this method are the same as in the above-described method. AX or $MX_2$ may be vapor-deposited instead of application of the AX solution and the $MX_2$ solution.

Still another example of the method includes a dry-type method such as a vacuum deposition by using a compound or a mixture from which a solvent of the light absorbing agent solution is removed. For example, a method of simultaneously or sequentially vapor-depositing AX and $MX_2$ may be exemplified.

According to the methods and the like, the perovskite compound is formed on the surface of the porous layer 12, the blocking layer 14, or the electron transport layer as the photosensitive layer.

The charge transport layer 3 is formed on the photosensitive layer 13 that is provided as described above.

The charge transport layer 3 can be formed through application and drying of a charge transporting material solution that contains a charge transporting material. In the charge transporting material solution, a concentration of the charge transporting material is preferably 0.1% to 50% by mass when considering that application properties are excellent, and in a case of providing the porous layer 12, the charge transporting material solution easily intrudes to the inside of pores of the porous layer 12.

Then, the particle-containing layer 4 is formed on the charge transport layer 3.

In a case of forming the particle-containing layer 4, a formation liquid that contains conductive fine particles and a polymer is prepared. Typically, the formation liquid is prepared as a dispersion liquid of the conductive fine particles. The conductive fine particles and the polymer are as follows. The amount of the conductive fine particles contained in the formation liquid is not particularly limited as long as a charge transporting function can be given to the particle-containing layer 4. For example, 0.0001% to 99.99% by mass is preferable, 0.0002% to 90% by mass is more preferable, and 0.001% to 50% by mass is still more preferable. Similarly, the amount of the polymer contained in the formation liquid is not particularly limited, but for example, 0.0001% to 99.99% by mass is preferable, and 0.001% to 50% by mass is more preferable. In the formation liquid, a ratio between the amount of the conductive fine particles contained and the amount of the polymer contained is not particularly limited as long as the charge transporting function can be given to the particle-containing layer 4. For example, the ratio between the amounts [the amount of the conductive fine particles contained:the amount of the polymer contained] is preferably 999:1 to 1:999, and more preferably 99:1 to 1:99.

Next, the formation liquid that is prepared is brought into contact with the surface of the charge transport layer 3. Specifically, application or immersion into the formation liquid is preferable. A contact temperature is preferably 10°C to 150°C, and more preferably 20°C to 100°C. Immersion time is preferably 1 second to 5 hours, and more preferably 10 seconds to 1 hour. In a case of drying the formation liquid, with regard to the drying, drying with heat is preferable, and the drying is performed by heating the formation liquid typically at 10°C to 200°C, and preferably at 20°C to 100°C.

In a case of forming a particle-containing layer 4, which includes the mixed layer 4a and the fine particle layer 4b, as the particle-containing layer 4, for example, the following methods may be exemplified. Specifically, examples of the methods include a method in which the ratio of the conductive fine particles in an application liquid is adjusted to be rich with respect to the amount of the polymer contained, preferably, in the above-described range, and a layer (fine particle layer 4b) not including the polymer is formed on an application surface, a method in which the fine particle layer 4b is formed by washing the application surface with an organic solvent after application and drying in order for only a polymer component to be removed, a method in which the conductive fine particle layer is physically exposed through polishing, and the like.

Next, after forming the particle-containing layer 4, the second electrode 2 is formed as necessary. The second electrode 2 can be formed in the same manner as in the first electrode 1, and can be formed through vapor deposition and the like.

In addition, in a case of forming the second electrode 2 with a carbon material and the like, the second electrode 2 can be formed by bringing an electrode forming liquid, which contains the carbon material, into contact with the particle-containing layer 4, and by drying the electrode forming liquid as necessary.

In this manner, the photoelectric conversion element 10 is manufactured.

The film thicknesses of the respective layers can be adjusted by appropriately changing the concentrations of respective dispersion liquids or solutions and the number of times of application. For example, in a case of providing the photosensitive layer 13 having a large film thickness, a light absorbing agent solution may be applied and dried a plurality of times.

The dispersion liquids, the solutions, and the formation liquids described above may respectively contain an additive such as a dispersion auxiliary agent and a surfactant as necessary.

Examples of the solvent or dispersion medium that is used in the method of manufacturing the photoelectric conversion element include a solvent described in JP2001-291534A, but the solvent or dispersion medium is not particularly limited thereto. In the invention, an organic solvent is preferable, and an alcohol solvent, an amide solvent, a nitrile solvent, a hydrocarbon solvent, a lactone solvent, a halogen solvent, a sulfide solvent, and a mixed solvent of two or more kinds thereof are preferable. As the mixed solvent, a mixed solvent of the alcohol solvent and a solvent selected from the amide solvent, the nitrile solvent, and the hydrocarbon solvent is preferable. Specifically, methanol, ethanol, isopropanol, γ-butyrolactone, n-propylsulfide, chlorobenzene, acetonitrile, N,N-dimethylformamide (DMF), dimethylacetamide, and a mixed solvent thereof are preferable.

A method of applying the solutions, dispersants, and the formation liquids which form the respective layers is not particularly limited, and it is possible to use a known application method such as spin coating, extrusion die coating, blade coating, bar coating, screen printing, stencil printing, roll coating, curtain coating, spray coating, dip coating, an inkjet printing method, and an immersion method. Among these, spin coating, screen printing, and the like are preferable.

The photoelectric conversion element of the invention may be subjected to an efficiency stabilizing treatment such as annealing, light soaking, and being left as is in an oxygen atmosphere as necessary.

The photoelectric conversion element prepared as described above can be used as a solar cell after connecting the external circuit 6 to the first electrode 1 (transparent electrode 11b) and the second electrode 2.

Examples

Hereinafter, the invention will be described in more detail on the basis of examples, but the invention is not limited to the following examples.

Example 1

(Manufacturing of Photoelectric Conversion Element (Sample No. 1 01))

The photoelectric conversion element 10A illustrated in Fig. 1 was prepared in the following procedure.

<Preparation of Conductive Support 11>

A fluorine-doped $SnO_2$ conductive film (the transparent electrode 11b, film thickness: 300 nm) was formed on a glass substrate (the support 11a, thickness: 2 mm), thereby preparing the conductive support 11.

<Formation of Blocking Layer 14>

An isopropanol solution, which contains 15% by mass of titanium diisopropoxide bis(acetylacetonate) (manufactured by Sigma-Aldrich Co. LLC) was diluted with 1-butanol, thereby preparing 0.02 M (mol/L) solution for a blocking layer.

The blocking layer 14 formed from titanium oxide (film thickness: 50 nm) was formed on the $SnO_2$ conductive film of the conductive support 11 by using the prepared 0.02 M solution for the blocking layer at 450°C in accordance with a spray pyrolysis method.

<Formation of Porous Layer 12>

Ethyl cellulose, lauric acid, and terpineol were added to an ethanol dispersion liquid of titanium oxide (anatase,

an average particle size: 20 nm), thereby preparing titanium oxide paste.

The prepared titanium oxide paste was applied onto the blocking layer 14 with a screen printing method, and was baked. Application and baking of the titanium oxide paste were respectively performed two times. With regard to a baking temperature, first baking was performed at 130°C, and second baking was performed at 500°C for 1 hour. A baked body of the titanium oxide, which was obtained, was immersed in 40 mM TiCl4 aqueous solution, and was heated at 60°C for 1 hour, and heating was continuously performed at 500°C for 30 minutes, thereby forming the porous layer 12 (film thickness: 250 nm) formed from $TiO_2$.

<Formation of Photosensitive Layer 13>

A 40% methanol solution (27.86 mL) of methyl amine, and an aqueous solution of 57% by mass of hydrogen iodide (hydroiodic acid: 30 mL) were stirred in a flask at 0°C for 2 hours, and was concentrated to obtain coarse $CH_3NH_3I$. The obtained coarse $CH_3NH_3I$ was dissolved in ethanol and was recrystallized with diethylether. A crystal that was obtained was filtered and collected, and was dried under reduced pressure at 60°C for 5 hours, thereby obtaining purified $CH_3NH_3I$. The purified $CH_3NH_3I$ that was obtained and $PbI_2$ were stirred and mixed at a molar ratio of 3:1 in DMF at 60°C for 12 hours, and the resultant mixture was filtered with a polytetrafluoroethylene (PTFE) syringe filter, thereby preparing a light absorbing agent solution of 40% by mass.

The light absorbing agent solution that was prepared was applied onto the porous layer 12 by a spin coating method (for 60 seconds at 2000 rpm). The applied light absorbing agent solution was dried by using a hot plate at 100°C for 60 minutes, thereby forming the photosensitive layer 13 (film thickness: 300 nm (including the film thickness of 250 nm of the porous layer 12)) that contains a perovskite compound of $CH_3NH_3PbI_3$.

In this manner, the first electrode 1A was prepared.

<Formation of Charge Transport Layer 3>

Poly(3-hexylthiophene-2,5-diyl) (number-average molecular weight: 30,000, 180 mg) as a hole transporting material was dissolved in chlorobenzene (1 mL). 37.5 $\mu$L of an acetonitrile solution obtained by dissolving lithium-bis (trifluoromethanesulfonyl) imide (170 mg) in acetonitrile (1 mL) and t-butyl pyridine (TBP, 17.5 $\mu$L) were additionally mixed to the chlorobenzene solution, thereby preparing a solution for the charge transport layer.

The prepared solution for the charge transport layer was applied onto the photosensitive layer 13 of the first electrode 1A by a spin coating method (for 30 seconds at 3,000 rpm). The applied charge transporting material solution was dried by using a hot plate at 30°C for 3 hours, thereby forming the charge transport layer 3 (film thickness: 100 nm) having a solid shape.

<Formation of Particle-Containing Layer 4>

Poly(3-hexylthiophene-2,5-diyl) (weight-average molecular weight: 40,000) and silver fine particles (an average particle size: 20 to 100 nm, an aspect ratio: 1 to 20) were put into toluene in a ratio of 1:3 in terms of a mass ratio, thereby preparing a formation liquid. A total solid-content concentration of the prepared liquid was 10% by mass.

Next, the prepared formation liquid was applied onto the charge transport layer 3 by a spin coating method (for 30 seconds at 3000 rpm). The applied formation liquid was dried by using a hot plate at 50°C for 2 hours, thereby forming the particle-containing layer 4 (film thickness: 120 nm).

The particle-containing layer 4 had a two-layer structure including the mixed layer 4a and the fine particle layer 4b. The thickness of the mixed layer 4a was 100 nm, and the thickness of the fine particle layer 4b was 20 nm.

<Preparation of Second Electrode 2>

Silver was vapor-deposited on the particle-containing layer 4 by a deposition method, thereby preparing the second electrode 2 (film thickness: 100 nm).

In this manner, the photoelectric conversion element 10A (Sample No. 101) was manufactured.

Respective film thicknesses were measured through observation with a SEM according to the above-described method.

(Manufacturing of Photoelectric Conversion Elements (Sample Nos. 102 to 105, 107, and 108))

Photoelectric conversion elements (Sample Nos. 102 to 105, 107, and 108) were manufactured in the same manner as in the manufacturing of the photoelectric conversion element (Sample No. 101) except that the hole transporting material of the charge transport material solution, or the polymer or the conductive fine particles of the formation liquid was changed to a compound illustrated in Table 1 in comparison to the manufacturing of the photoelectric conversion element (Sample No. 101).

In carbon black (CB) that was used in Sample No. 102, and the like, an average particle size was 5 to 50 nm and an aspect ratio was 1 to 10.

In addition, weight-average molecular weights of PMMA, ABS, and PC were respectively 15,000, 8,000, and 150,000.

(Manufacturing of Photoelectric Conversion Element (Sample No. 106))

A photoelectric conversion element (Sample No. 106) was prepared in the same manner as in the manufacturing of the photoelectric conversion element (Sample No. 104) except that the second electrode 2 was formed as follows by using carbon black instead of silver in comparison to the manufacturing of the photoelectric conversion element (Sample No. 104).

The second electrode 2 (film thickness: 150 nm) was formed as follows. An electrode formation liquid containing 9% by mass of carbon black (an average particle size: 5 to 50 nm, an aspect ratio: 1 to 10) was applied onto the particle-containing layer 4 by a spin coating method (for 30 seconds at 3,000 rpm). The applied electrode formation liquid was dried by using a hot plate at 70°C for 60 minutes, thereby forming the second electrode 2.

(Manufacturing of Photoelectric Conversion Element (Sample No. 109))

A photoelectric conversion element (Sample NO. 109) is the photoelectric conversion element 10C illustrated in Fig. 3, and the particle-containing layer 4 also functions as the second electrode 2.

The photoelectric conversion element (Sample No. 109) was manufactured in the same manner as in the manufacturing of the photoelectric conversion element (Sample No. 101) except that manufacturing of the second electrode 2 was not performed in comparison to the manufacturing of the photoelectric conversion element (Sample No. 101).

(Manufacturing of Photoelectric Conversion Element (Sample No. c11))

A photoelectric conversion element (Sample No. c11) was manufactured in the same manner as in the manufacturing of the photoelectric conversion element (Sample No. 104) except that the particle-containing layer 4 is not formed in comparison to the manufacturing of the photoelectric conversion element (Sample No. 104).

(Manufacturing of Photoelectric Conversion Element (Sample No. c12))

A photoelectric conversion element (Sample No. c12) was manufactured in the same manner as in a method described in Experiment Example (column of Methods) of Nano lett, 2014, 14, p. 5561-5568.

With respect to Sample No. c12, respective layers and components, and the like are described in Table 1 in a convenient manner for easy comparison with the photoelectric conversion elements of the invention. Accordingly, the photoelectric conversion element of Sample No. c12 has a structure described in Nano lett, 2014, 14, p. 5561-5568, and the like, and is not intended to have a structure illustrated in Table 1, and the like.

(Manufacturing of Photoelectric Conversion Element (Sample No. c13))

A photoelectric conversion element (Sample No. c13) was manufactured in the same manner as in the manufacturing of the photoelectric conversion element (Sample No. 101) except that the charge transport layer 3 was not formed in comparison to the manufacturing of the photoelectric conversion element (Sample No. 101).

<Evaluation of Variation in Initial Photoelectric Conversion Efficiency>

Seven specimens of photoelectric conversion elements were manufactured for each of the sample numbers in the same manner as in the methods of manufacturing the photoelectric conversion elements. A battery characteristic test was performed with respect to respective photoelectric conversion elements of each of the sample numbers to measure initial photoelectric conversion efficiency ($\eta^I$/%). The battery characteristic test was performed through irradiation of pseudo-solar light of 1000 W/$m^2$ from a xenon lamp through an AM1.5 filter by using a solar simulator "WXS-85H" (manufactured by Wacom). The initial photoelectric conversion efficiency ($\eta^I$) was obtained by measuring current-voltage characteristics by using an I-V tester.

An average value ($\eta^I_{av}$) of the initial photoelectric conversion efficiency was obtained in the photoelectric conversion elements of each of the sample numbers. The average value ($\eta^I_{av}$) of the initial photoelectric conversion efficiency was set to 1 (reference), and deviations (differences) ($\eta^D$ = initial photoelectric conversion efficiency ($\eta^I$) of a photoelectric

conversion element - the average value average value ($\eta^{I}_{av}$)) from the average value ($\eta^{I}_{av}$) were calculated with respect to the photoelectric conversion elements. Ranges, which include the maximum value (value in which an absolute value of a difference becomes the maximum) among the differences ($\eta^{D}$) of the initial photoelectric conversion efficiency which were obtained as described above, were classified in accordance with the following criteria to evaluate the variation in the initial photoelectric conversion efficiency.

In the evaluation criteria of the variation in the initial photoelectric conversion efficiency, a passing level in this test is Evaluation "C" or higher, and preferably Evaluation "B" and Evaluation "A". Results are illustrated in the following Table 1.

- Evaluation Criteria of Variation in Initial Photoelectric Conversion Efficiency -

With regard to the maximum value among differences ($\eta^{D}$) of the initial photoelectric conversion efficiency, criteria are as follows.

A: Maximum value is in a range of ±0.11
B: Maximum value is beyond a range of ±0.11, and is in a range of ±0.15
C: Maximum value is beyond a range of ±0.15, and is in a range of ±0.20
D: Maximum value is beyond a range of ±0.20, and is in a range of ±0.27
E: Maximum value is beyond a range of ±0.27

It was confirmed that the initial photoelectric conversion efficiency, which was measured in the evaluation of the variation in the initial photoelectric conversion efficiency, of the photoelectric conversion element (Sample No. 101), was 6% or greater at which a solar cell can sufficiently function.

<Evaluation of Durability Variation>

Seven specimens of photoelectric conversion elements were manufactured for each of the sample numbers in the same manner as in the methods of manufacturing the photoelectric conversion elements. After photoelectric conversion elements of each of the sample numbers were left under an environment of 50°C and 60 RH% for 50 hours, with respect to the photoelectric conversion elements, photoelectric conversion efficiency ($\eta^{R}$/%) after a durability test was obtained by the battery characteristic test.

In the photoelectric conversion elements, a retention rate ($\eta^{M}$) of the photoelectric conversion efficiency was calculated from the following Expression.

$$\text{Expression } \eta^{M}=\eta^{R}/\eta^{I}$$

In Expression, $\eta^{I}$ represents the initial photoelectric conversion efficiency (%), and $\eta^{R}$ represents photoelectric conversion efficiency (%) after the durability test.

An average value ($\eta^{M}_{av}$) of the retention rate ($\eta^{M}$) of the photoelectric conversion efficiency was obtained, and the average value ($\eta^{M}_{av}$) was set to 1 (reference). With respect to the photoelectric conversion elements, deviations (differences) ($\eta^{M2}$ = a retention rate ($\eta^{M}$) of a photoelectric conversion element - average value ($\eta^{M}_{av}$)) from the average value ($\eta^{M}_{av}$) were calculated. Ranges, which include the maximum value (value in which an absolute value of a difference becomes the maximum) among the differences ($\eta^{M2}$) of the retention rate of the photoelectric conversion efficiency which were obtained as described above, were classified in accordance with the following criteria to evaluate the durability variation.

In the evaluation criteria of the durability variation, a passing level in this test is Evaluation "C" or higher, and preferably Evaluation "B" and Evaluation "A". Results are illustrated in the following Table 1.

- Evaluation Criteria of Durability Variation -

With regard to the maximum value among differences ($\eta^{M2}$) of the retention rate of the initial photoelectric conversion efficiency, criteria are as follows.

A: Maximum value is in a range of ±0.11
B: Maximum value is beyond a range of ±0.11, and is in a range of ±0.14
C: Maximum value is beyond a range of ±0.14, and is in a range of ±0.19

D: Maximum value is beyond a range of ±0.19 and is in a range of ±0.25
E: Maximum value is beyond a range of ±0.25

[Table 1]

| Sample No. | Perovskite-type light absorbing agent | Charge transporting material (charge transport layer) | Formation liquid (particle-containing layer) | | Second electrode | Variation in initial photoelectric conversion efficiency | Variation in durability | Remarks |
|---|---|---|---|---|---|---|---|---|
| | | | Polymer | Conductive particles | | | | |
| c11 | $CH_3NH_3PbI_3$ | spiro-MeOTAD | - | - | Ag | E | E | Comparative Example |
| c12 | $CH_3NH_3PbI_3$ | P3HT | PMMA | CNT | Ag | D | D | Comparative Example |
| c13 | $CH_3NH_3PbI_3$ | - | P3HT | Ag | Ag | E | E | Comparative Example |
| 101 | $CH_3NH_3PbI_3$ | P3HT | P3HT | Ag | Ag | C | C | Present Invention |
| 102 | $CH_3NH_3PbI_3$ | P3HT | P3HT | CB | Ag | B | B | Present Invention |
| 103 | $CH_3NH_3PbI_3$ | P3HT | PMMA | CB | Ag | A | A | Present Invention |
| 104 | $CH_3NH_3PbI_3$ | spiro-MeOTAD | PMMA | CB | Ag | A | A | Present Invention |
| 105 | $CH_3NH_3PbI_3$ | spiro-MeOTAD | PMMA | Ag | Ag | B | B | Present Invention |
| 106 | $CH_3NH_3PbI_3$ | spiro-MeOTAD | PMMA | CB | CB | A | A | Present Invention |
| 107 | $CH_3NH_3PbI_3$ | spiro-MeOTAD | ABS | CB | Ag | A | A | Present Invention |
| 108 | $CH_3NH_3PbI_3$ | spiro-MeOTAD | PC | CB | Ag | A | A | Present Invention |
| 109 | $CH_3NH_3PbI_3$ | P3HT | P3HT | Ag | - | C | C | Present Invention |

In table 1, CNT represents a carbon nanotube, spiro-MeOTAD represents 2,2',7,7'-tetrakis-(N,N-di-p-methoxyphenylamino)-9,9'-spirobifluorene, P3HT represents poly(3-hexylthiophene-2,5-diyl), PMMA represents polymethyl methacrylate, ABS represents an acrylonitrile-butadiene-styrene copolymer resin, PC represents polycarbonate, and CB represents carbon black (average particle size: 5 to 50 nm, aspect ratio: 1 to 10).
From results in Table 1, even in a photoelectric conversion element that uses a perovskite compound as a light absorbing agent, in a case where the charge transport layer 3 and the particle-containing layer 4 are provided on the first electrode 1A (Sample Nos. 101 to 109), it could be seen that a variation in initial photoelectric conversion efficiency is small, and a variation (durability variation) in a deterioration amount of photoelectric conversion efficiency after passage of a predetermined period is small.
Particularly, in a case where the polymer contained in the particle-containing layer 4 is an insulating material, and the conductive fine particles are fine particles of a carbon material, it could be seen that it is possible to further reduce the variation in the initial photoelectric conversion efficiency and the variation in the deterioration amount of the photoelectric conversion efficiency after passage of a predetermined period.
The two variation reducing effects were also true of an aspect in which the particle-containing layer 4 also functions as the second electrode 2, and the effects were also excellent.
In contrast, in all of the photoelectric conversion elements (Sample Nos. c11 to c13) in which at least one of the charge transport layer or the particle-containing layer is not provided, it could be seen that it is difficult to sufficiently reduce the variation in the initial photoelectric conversion efficiency, and the variation in the deterioration amount of the photoelectric conversion efficiency after passage of a predetermined period. Particularly, even in a case where the charge transport layer and the PMMA layer that contains a carbon nanotube are provided (photoelectric conversion element (Sample No. c12), a reduction in the variation was not sufficient.

Example 2

(Manufacturing of Photoelectric Conversion Elements (Sample Nos. 201 to 208))

The photoelectric conversion element 10D illustrated in Fig. 4 was manufactured by the following procedure.
Photoelectric conversion elements 10D (Sample Nos. 201 to 208) were manufactured in the same manner as in the manufacturing of the photoelectric conversion elements (Sample Nos. 101 to 108) except that the porous layer 12 was not provided and the photosensitive layer 13 was provided on the blocking layer 14 in comparison to the manufacturing of the photoelectric conversion elements (Sample Nos. 101 to 108).

(Manufacturing of Photoelectric Conversion Element (Sample No. 209))

The photoelectric conversion element 10F illustrated in Fig. 6 was manufactured in the following procedure.
The photoelectric conversion element 10F (Sample No. 209) was manufactured in the same manner as in the manufacturing of the photoelectric conversion element (Sample No. 109) except that the porous layer 12 was not provided, and the photosensitive layer 13 was provided on the blocking layer 14 in comparison to the manufacturing of the photoelectric conversion element (Sample No. 109).
With respect to the photoelectric conversion elements which were manufactured, the variation in the initial photoelectric conversion efficiency and the durability deviation were evaluated in the same manner as in Example 1. As a result, the entirety of the photoelectric conversion elements which were obtained exhibited the same excellent effect as in the photoelectric conversion elements of Example 1.
The invention has been described in combination with embodiments thereof. However, it is not intended to limit the invention in any detailed part of the description unless particularly specified, and it should be understood that the invention is supposed to be widely interpreted within the spirit and the scope of the invention which are described in the appended claims.
Priority is claimed on Japanese Patent Application No. 2015-128512, filed June 26, 2015, the content of which is incorporated herein by reference. Explanation of References
1A, 1B: first electrode
11: conductive support
11a: support
11b: transparent electrode
12: porous layer
13: photosensitive layer
14: blocking layer

2: second electrode
3: charge transport layer (hole transport layer)
4: particle-containing layer
4a: mixed layer
4b: fine-particle layer
6: external circuit (lead)
10A to 10F: photoelectric conversion element
100A to 100F: system using solar cell
M: electric motor

## Claims

**1.** A photoelectric conversion element, comprising:

a first electrode that includes a photosensitive layer, which includes a perovskite-type light absorbing agent, on a conductive support;
a particle-containing layer that contains conductive fine particles and a polymer and is provided on the first electrode; and
a charge transport layer that does not contain the conductive fine particles and is provided between the photosensitive layer and the particle-containing layer.

**2.** The photoelectric conversion element according to claim 1,

wherein the charge transport layer is a hole transport layer.

**3.** The photoelectric conversion element according to claim 1 or 2,

wherein the polymer is an insulating material.

**4.** The photoelectric conversion element according to any one of claims 1 to 3,

wherein the conductive fine particles are fine particles of a carbon material.

**5.** The photoelectric conversion element according to any one of claims 1 to 4, further comprising:

a second electrode that is opposite to the first electrode and is provided on the particle-containing layer.

**6.** The photoelectric conversion element according to any one of claims 1 to 4,

wherein the particle-containing layer also functions as a second electrode that is opposite to the first electrode.

**7.** The photoelectric conversion element according to any one of claims 1 to 6,

wherein the perovskite-type light absorbing agent includes a compound having a perovskite-type crystal structure that includes a cation of elements of Group 1 in the periodic table or a cationic organic group A, a cation of a metal atom other than elements of Group 1 in the periodic table, and an anion of an anionic atom or atomic group X.

**8.** The photoelectric conversion element according to any one of claims 1 to 7, further comprising:

a porous layer that is provided between the conductive support and the photosensitive layer.

**9.** A solar cell that uses the photoelectric conversion element according to any one of claims 1 to 8.

FIG. 1

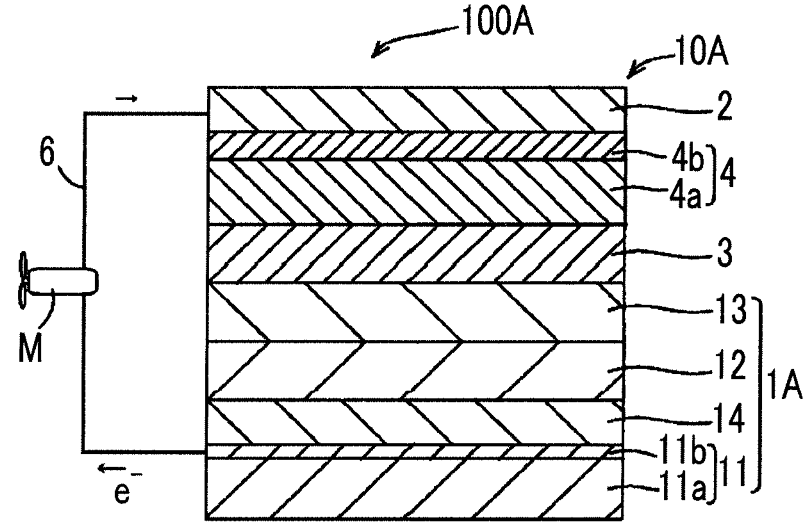
100A
10A
2
4b
4
4a
3
13
12
1A
14
11b
11
11a
6
M
e⁻

FIG. 2

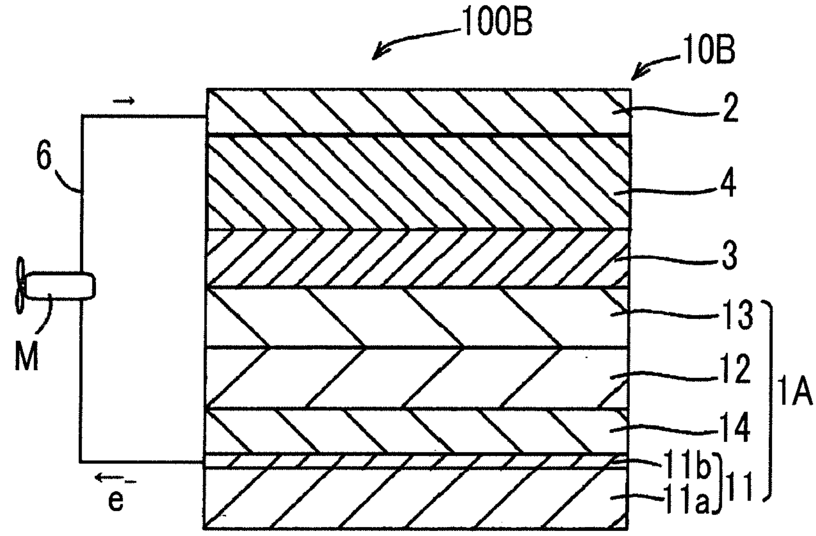
100B
10B
2
4
3
13
12
1A
14
11b
11
11a
6
M
e⁻

FIG. 3

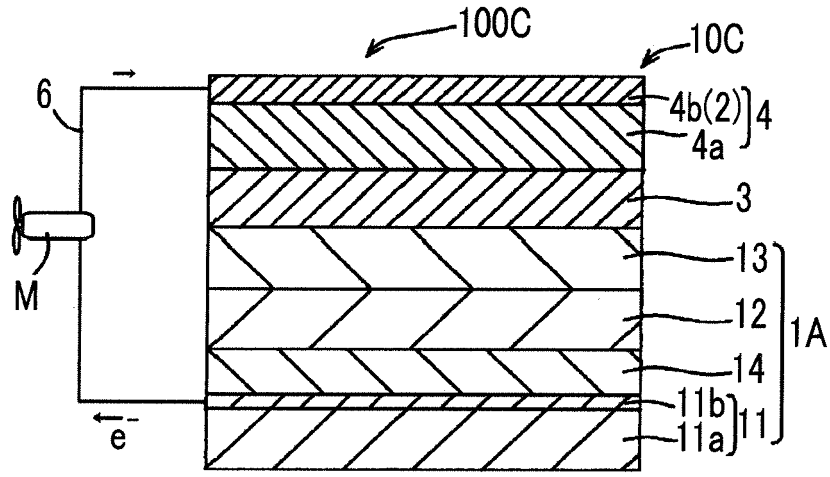
100C
10C
6
4b(2)
4
4a
3
13
12
1A
14
11b
11
11a
M
e⁻

FIG. 4

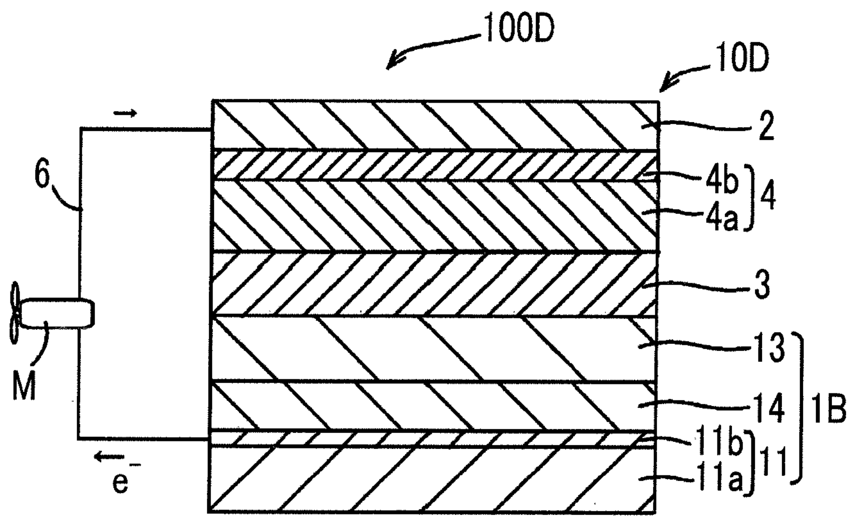
100D
10D
6
2
4b
4
4a
3
13
14
1B
11b
11
11a
M
e⁻

FIG. 5

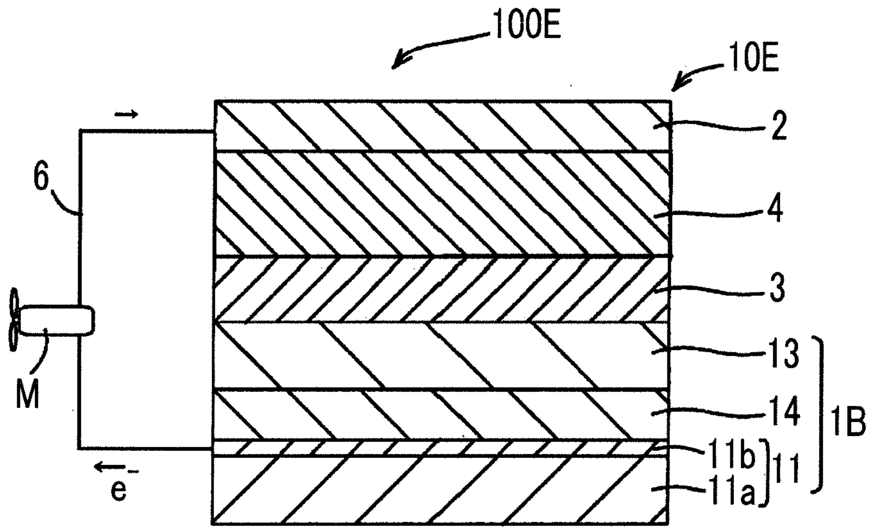
100E
10E
2
4
3
13
14
1B
11b
11
11a
6
M
e-

FIG. 6

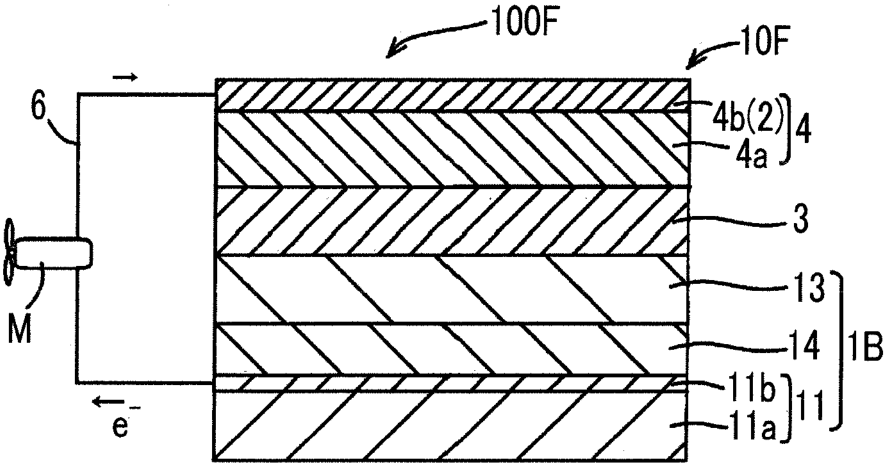
100F
10F
4b(2)
4
4a
3
13
14
1B
11b
11
11a
6
M
e-

**INTERNATIONAL SEARCH REPORT**

International application No.
PCT/JP2016/068385

A. CLASSIFICATION OF SUBJECT MATTER
*H01L51/44*(2006.01)i

According to International Patent Classification (IPC) or to both national classification and IPC

B. FIELDS SEARCHED

Minimum documentation searched (classification system followed by classification symbols)
H01L51/44

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | Severin N. Habisreutinger, Carbon Nanotube/ Polymer Compositesas a Highly Stable Hole Collection Layer in Perovskite Solar Cells, NANO LETTERS, 2014.09.16, Vol.14, No.10, 5561-5568 | 1-6,8-9<br>7 |
| Y | JP 2015-046585 A (Fujifilm Corp.), 12 March 2015 (12.03.2015), paragraph [0068] & WO 2015/016201 A1 | 7 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 August 2016 (04.08.16) | 16 August 2016 (16.08.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2001291534 A
- US 4927721 A
- US 4684537 A
- US 5084365 A
- US 5350644 A
- US 5463057 A
- US 5525440 A
- JP 7249790 A
- JP H7249790 A
- JP 2004220974 A
- JP 2008135197 A
- JP 2005135902 A
- JP 2001160425 A
- JP 2003123859 A
- JP 2002260746 A
- JP 2015128512 A

### Non-patent literature cited in the description

- *Science,* 2012, vol. 338, 643-647
- *Nano lett,* 2014, vol. 14, 5561-5568
- *J. Am. Chem. Soc.,* 2009, vol. 131 (17), 6050-6051
- *Nano lett,* 2014, vol. 14, 5561-5568
- **AKIHIRO KOJIMA ; KENJIRO TESHIMA ; YASUO SHIRAI ; TSUTOMU MIYASAKA.** Organometal Halide Perovskites as Visible-Light Sensitizers for Photovoltaic Cells. *J. Am. Chem. Soc.,* 2009, vol. 131 (17), 6050-6051
- *J. Am. Chem. Soc.,* 2009, vol. 131 (17), 6050-6051
- *Chemical Review,* 2010, vol. 110, 6595
- *Experiment Example (column of Methods) of Nano lett,* 2014, vol. 14, 5561-5568